(19) Europäisches Patentamt
European Patent Office
Office européen des brevets

(11) EP 4 520 798 A1

(12) EUROPEAN PATENT APPLICATION

(43) Date of publication:
**12.03.2025 Bulletin 2025/11**

(21) Application number: **24198184.4**

(22) Date of filing: **03.09.2024**

(51) International Patent Classification (IPC):
***C09G 1/02*** *(2006.01)* ***C09K 3/14*** *(2006.01)*
***H01L 21/3105*** *(2006.01)* ***H01L 21/321*** *(2006.01)*

(52) Cooperative Patent Classification (CPC):
**C09G 1/02; C09K 3/1463; H01L 21/31053; H01L 21/3212**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **11.09.2023 US 202363537636 P**

(71) Applicant: **Fujimi Incorporated**
**Kiyosu-shi, Aichi 452-8502 (JP)**

(72) Inventors:
- **Onishi, Shogo**
  **Tualatin, Oregon, 97062 (US)**
- **Kim, Anthony Y.**
  **Tualatin, Oregon, 97062 (US)**
- **Carlson, Alexandra**
  **Tualatin, Oregon, 97062 (US)**

(74) Representative: **Grünecker Patent- und Rechtsanwälte**
**PartG mbB**
**Leopoldstraße 4**
**80802 München (DE)**

# (54) POLISHING COMPOSITION AND METHOD FOR POLISHING SUBSTRATE USING THE COMPOSITION

(57) The present disclosure relates to a polishing compositions that increase a silicon oxide removal rate without impairing the stability of an abrasive. The present disclosure relates to a polishing composition comprising an abrasive, a base compound, a silicon oxide removal rate controller, and an oxidizer, wherein the abrasive is a silica abrasive with a primary particle size ranging from about 30 nm to about 70 nm and a secondary particle size ranging from about 50 nm to about 130 nm; the base compound is an inorganic base; the silicon oxide removal rate controller is a zwitterion; and the oxidizer is a peroxide.



Processed by Luminess, 75001 PARIS (FR)

## Description

### CROSS-REFERENCE TO RELATED APPLICATION

This application is based on the foreign language specification submitted as attachment to the application of U.S. Provisional Application No. 63/537,636, filed on Sep. 11, 2023, the disclosure of which is incorporated herein by reference in its entirety.

### TECHNICAL FIELD

The present disclosure relates to silicon oxide (e.g., tetraethyl orthosilicate (TEOS)) chemical mechanical polishing (CMP) compositions with silicon oxide removal rate controllers. More particularly, the silicon oxide CMP compositions comprise an abrasive, a silicon oxide removal rate controller, a basic component, and an oxidizer, combined in specified amounts to increase silicon oxide (e.g., TEOS) removal rates while having high stability. The silicon oxide CMP compositions comprise an abrasive, a silicon oxide removal rate controller, a basic component, and an oxidizer, combined in specified amounts to provide not only high silicon oxide (e.g., TEOS) removal rates but also high tantalum (Ta) removal rates and/or copper (Cu) removal rates.

### BACKGROUND

Chemical mechanical polishing (CMP) is a process in which material is removed from the surface of a substrate (such as a semiconductor wafer), and the surface is polished (planarized) by coupling a physical process, such as abrasion, with a chemical process, such as oxidation or chelation. In its most rudimentary form, CMP involves applying a polishing composition to the surface of the substrate or a polishing pad that polishes the substrate. This process achieves both the removal of unwanted material and planarization of the surface of the substrate. It is not desirable for the removal or polishing process to be purely physical or purely chemical, but rather comprise a synergistic combination of both.

CMP is used on a large variety of objects, examples of which include silicon dioxide ($SiO_2$) in inter-layer or buried dielectrics, metals such as aluminum (Al), copper (Cu), and tungsten (W) in wiring layers or plugs connecting to such a wiring layer, a barrier metal layer such as tantalum (Ta), tantalum nitride (TaN), and titanium (Ti), polysilicon for use as a trench capacitor, and silicon nitride, which is used in a wide range of applications. Examples for the use of silicon nitride include dielectric materials, passivation layers, etching masks, and the like.

The CMP process is typically carried out in a two-step sequence. The first step is specifically designed to rapidly remove interconnected metal, such as copper, from the surface of a substrate. The second step removes the barrier layer, such as Ta, while attempting to not adversely affect the physical structure or electrical properties of the interconnected metal structure.

During removal of the barrier (such as a Ta) layer, the underlying layer may also be removed partially or completely. This underlying layer is often a silicon oxide-containing material, such as silicon oxide (e.g., tetraethyl orthosilicate (TEOS)). Silicon oxide (e.g., TEOS) is generally used as a thin film in semiconductors and may require removal to modify the thickness of the silicon oxide (e.g., TEOS) thin film and/or surface properties of the film, e.g., roughness.

Thus, developing polishing compositions that would be able to remove various layers made of different materials with high efficiency (i.e., high removal rate) would be highly desirable.

### SUMMARY OF INVENTION

In accordance with the purpose(s) of the currently disclosed subject matter or problems to be solved by the invention, as embodied and broadly described herein, it is an object of the present invention to provide a composition for polishing substrates that increases silicon oxide (e.g., TEOS) removal rates while having high stability. It is another object of the present invention to provide a composition for polishing substrates, such as silicon oxide (e.g., tetraethyl orthosilicate (TEOS)), tantalum (Ta), and/or copper (Cu), that facilitate improvement in polishing speeds when using CMP.

Accordingly, the presently disclosed subject matter in one aspect relates to a polishing composition comprising an abrasive, a base compound, a silicon oxide removal rate controller, and an oxidizer, wherein the abrasive is a silica abrasive with a primary particle size ranging from about 30 nm to about 70 nm and a secondary particle size ranging from about 50 nm to about 130 nm; the base compound being an inorganic base; the silicon oxide removal rate controller being a zwitterion; and the oxidizer being a peroxide.

According to an embodiment, in the polishing composition, the silicon oxide removal rate controller has a pKa ranging from about 7 to about 11.

In an embodiment, the polishing composition can further comprise an acid selected from the group consisting of

citric acid, nitric acid, phosphoric acid, maleic acid, tartaric acid, 1-hydroxyethylidene-1,1-diphosphonic acid (HEDP), glycolic acid, lactic acid, malic acid, hydroxybutyric acid, and a combination thereof.

In some embodiments, the polishing composition can further comprise benzotriazole.

In another aspect, the subject matter described herein is directed to a method for polishing a substrate, the method comprising the steps of: 1) providing the polishing composition described herein; 2) providing a substrate, wherein the substrate comprises one or more layers selected from a silicon oxide layer (e.g., TEOS layer), a Ta layer, and a Cu layer; and 3) polishing the substrate with the polishing composition to provide a polished substrate.

These and other aspects are disclosed in further detail below.

## DETAILED DESCRIPTION

The present invention can be understood more readily by reference to the following detailed description of the invention and the Examples included therein. The numerical range "A-B" in the present specification includes A and B and means "A or more and B or less". Further, "A and/or B" means "either A or B" or "both A and B".

Before the present compounds, compositions, articles, systems, devices, and/or methods are disclosed and described, it is to be understood that they are not limited to specific methods unless otherwise specified, or to particular components unless otherwise specified, as such may, of course, vary. It is also to be understood that the terminology used herein is for the purpose of describing particular aspects only, and is not intended to be limiting. Although, any methods and materials similar or equivalent to those described herein can be used in the practice or testing of the present invention, example methods and materials are now described.

As described herein, one aspect of the invention includes polishing compositions comprising an abrasive, a basic compound, a silicon oxide removal rate controller, and an oxidizer. These polishing compositions of the aspect are intended for polishing a substrate where the polishing compositions increase silicon oxide (e.g., TEOS) removal rate while having high stability. According to an embodiment, these polishing compositions have high stability and increased silicon oxide (e.g., TEOS) removal rate and exhibit at least one benefit such as increased Ta removal rate and increased Cu removal rate. According to an embodiment, these polishing compositions also exhibit a benefit such as 1) increased silicon oxide (e.g., TEOS) removal rate; 2) increased Ta removal rate; 3) increased Cu removal rate; and 4) high composition stability.

High stability, the silicon oxide (e.g., TEOS) removal rate, Ta removal rate, and Cu removal rate of the polishing compositions described herein are key properties. Compositions exhibiting these key properties may be obtained by use of specific components in requisite amounts. For example, in an embodiment, a polishing composition comprising an abrasive, a base compound, a silicon oxide removal rate controller, and an oxidizer has been found to provide a high silicon oxide (e.g., TEOS) removal rate and/or Ta removal rate and/or Cu removal rate, wherein the concentrations of each component of the polishing composition must be present in specific amounts to provide such high removal rate(s).

One of the main chemical mechanical polishing (CMP) challenges for semiconductor manufacturing is the selective polishing of certain materials. Copper (Cu) is widely used as an interconnect material in semiconductor device fabrication, while tantalum (Ta) is widely used as a barrier material. These copper (Cu) and tantalum (Ta) layers are often formed on a silicon oxide (e.g., TEOS) layer. In recent years, there has been a demand to remove the underlying silicon oxide (e.g., TEOS) layer while removing these copper (Cu) and tantalum (Ta) layers. In such a case, silicon oxide (e.g., TEOS) is polished at the same time as polishing of copper (Cu) or tantalum (Ta), but polishing of silicon oxide (e.g., TEOS) tends to be suppressed as compared with copper (Cu) or tantalum (Ta). Therefore, one of the objects is to increase the silicon oxide (e.g., TEOS) removal rate while having increased Ta removal rate and increased Cu removal rate, as well as satisfying the basic performance of ensuring the stability of abrasives.

The polishing compositions described herein have uses such as, but not limited to, the CMP of silicon oxide-containing substrates (e.g., TEOS-containing substrates), Ta-containing substrates, and/or Cu-containing substrates.

### A. Definitions

Listed below are definitions of various terms used to describe this invention. These definitions apply to the terms as they are used throughout this specification, unless otherwise limited in specific instances, either individually or as part of a larger group.

As used in the specification and the appended claims, the singular forms "a", "an" and "the" include plural referents unless the context clearly dictates otherwise. Thus, for example, reference to "an abrasive" or "a pH-adjusting agent" includes mixtures of two or more such abrasives or pH-adjusting agents.

Ranges can be expressed herein as from "about" one particular value, and/or to "about" another particular value. When such a range is expressed, another aspect includes from the one particular value and/or to the other particular value. Similarly, when values are expressed as approximations, by use of the antecedent "about," it will be understood that the particular value forms another aspect. It will be further understood that the endpoints of each of the ranges are significant

both in relation to the other endpoint, and independently of the other endpoint. It is also understood that there are a number of values disclosed herein, and that each value is herein disclosed as "about" that particular value in addition to the value itself. For example, if the value "10" is disclosed, then "about 10" is also disclosed. It is also understood that each unit between two particular units is also disclosed. For example, if 10 and 15 are disclosed, then 11, 12, 13, and 14 are also disclosed.

As used herein, examples of silicon oxide-containing substrates include layers (films) comprising TEOS (tetraethyl orthosilicate) type silicon oxide (hereinafter also simply referred to as "TEOS") produced using tetraethyl orthosilicate as a precursor, HDP (high density plasma), USG (undoped silicate glass), PSG (phosphorus silicate glass) films, BPSG (boron-phospho silicate glass), and RTO (rapid thermal oxidation),. As used therein, the term "TEOS" refers not only to tetraethyl orthosilicate specifically, but also refers to a silicon oxide (silicon dioxide; $SiO_2$) (silicon oxide layer) made from tetraethyl orthosilicate.

References in the specification and concluding claims to parts by weight of a particular element or component in a composition denote the weight relationship between the element or component and any other elements or components in the composition or article for which a part by weight is expressed. Thus, in a compound containing 2 parts by weight of component X and 5 parts by weight of component Y, X and Y are present at a weight ratio of 2:5, and are present in such ratio regardless of whether additional components are contained in the compositions.

A weight percent (wt%) of a component, unless specifically stated to the contrary, is based on the total weight of the vehicle or composition in which the component is included.

As used herein, the terms "optional" and "optionally" mean that the subsequently described event or circumstance can or cannot occur, and that the description includes instances where said event or circumstance occurs and instances where it does not.

As used herein, the term "alkyl" refers to a straight or branched chain hydrocarbon containing from 1 to 10 carbon atoms. Representative examples of alkyl include, but are not limited to, methyl, ethyl, n-propyl, isopropyl, n-butyl, sec-butyl, isobutyl, tert-butyl, n-pentyl, isopentyl, neopentyl, n-hexyl, 3-methylhexyl, 2,2-dimethylpentyl, 2,3-dimethylpentyl, n-heptyl, n-octyl, n-nonyl, n-decyl, and the like. These groups may be substituted with groups selected from halo (e.g., haloalkyl), alkyl, haloalkyl, alkenyl, alkynyl, cycloalkyl, cycloalkylalkyl, aryl, arylalkyl, heterocyclo, heterocycloalkyl, hydroxyl, alkoxy (thereby creating a polyalkoxy such as polyethylene glycol), alkenyloxy, alkynyloxy, haloalkoxy, cycloalkoxy, cycloalkylalkyloxy, aryloxy, arylalkyloxy, heterocyclooxy, heterocyclolalkyloxy, mercapto, carboxy, alkylamino, alkenylamino, alkynylamino, haloalkylamino, cycloalkylamino, cycloalkylalkylamino, arylamino, arylalkylamino, heterocycloamino, heterocycloalkylamino, disubstituted-amino, ester, amide, nitro, or cyano.

As used herein, the term "substituted" refers to a moiety (such as heteroaryl), wherein the moiety is bonded to one or more additional organic radicals. In some embodiments, the substituted moiety comprises 1, 2, 3, 4, or 5 additional substituent groups or radicals. Suitable organic substituent radicals include, but are not limited to, hydroxyl, amino, mono-substituted amino, di-substituted amino, mercapto, alkylthiol, alkoxy, substituted alkoxy or haloalkoxy radicals, wherein the terms are defined herein. Unless otherwise indicated herein, the organic substituents can comprise from 1 to 4 or from 5 to 8 carbon atoms. When a substituted moiety is bonded thereon with more than one substituent radical, then the substituent radicals may be the same or different.

As used herein, the term "alkoxy", used alone or as part of another group, means the radical -OR, where R is an alkyl group as defined herein.

As used herein, the term "halo" refers to any suitable halogen, including -F, -Cl, -Br, and -I.

As used herein, the term "mercapto" refers to an -SH group.

As used herein, the term "cyano" refers to a -CN group.

As used herein, the term "carboxylic acid" refers to a -C(O)OH group.

As used herein, the term "hydroxyl" refers to an -OH group.

As used herein, the term "nitro" refers to an $-NO_2$ group.

As used herein, the term "acyl", used alone or as part of another group, refers to a -C(O)R radical, where R is any suitable substituent such as aryl, alkyl, alkenyl, alkynyl, cycloalkyl or other suitable substituent as described herein.

As used herein, the term "alkylthio", used alone or as part of another group, refers to an alkyl group, as defined herein, appended to the parent molecular moiety through a thio moiety, as defined herein. Representative examples of alkylthio include, but are not limited, methylthio, ethylthio, tert-butylthio, hexylthio, and the like.

As used herein, the term "amino" means the radical $-NH_2$.

As used herein, the term "alkylamino" or "mono-substituted amino", used alone or as part of another group, means the radical -NHR, where R is an alkyl group.

As used herein, the term "disubstituted amino", used alone or as part of another group, means the radical $-NR_aR_b$, where $R_a$ and $R_b$ are independently selected from the groups alkyl, haloalkyl, alkenyl, alkynyl, cycloalkyl, cycloalkylalkyl, aryl, arylalkyl, heterocyclo, and heterocycloalkyl.

As used herein, the term "ester", used alone or as part of another group, refers to a - C(O)OR radical, where R is any suitable substituent such as alkyl, cycloalkyl, alkenyl, alkynyl or aryl.

As used herein, the term "amide", used alone or as part of another group, refers to a - $C(O)NR_aR_b$ radical, where $R_a$ and $R_b$ are any suitable substituent such as alkyl, cycloalkyl, alkenyl, alkynyl or aryl.
As used herein, the term "sulfonic acid" refers to a compound of the formula - S(O)(O)OH.
As used herein, the term "unsubstituted" refers to a moiety (such as alkyl) that is not bonded to one or more additional organic or inorganic substituent radical as described above, meaning that such a moiety is only substituted with hydrogens.
As used herein, the term "D10" refers to a parameter of a particle size distribution of particles (i.e., the abrasives disclosed herein), wherein D10 is defined as the particle size equivalent to 10% of the cumulative count from the smallest particle size distribution histogram.
As used herein, the term "D50" refers to a parameter of a particle size distribution of particles (i.e., the abrasives disclosed herein), wherein D50 is defined as the particle size equivalent to 50% of the cumulative count from the smallest particle size distribution histogram.
As used herein, the term "D90" refers to a parameter of a particle size distribution of particles (i.e., the abrasives disclosed herein), wherein D90 is defined as the particle size equivalent to 90% of the cumulative count from the smallest particle size distribution histogram.

B. Polishing Composition

The fundamental mechanism of CMP is to soften a surface layer by chemical reaction and then remove the softened layer by mechanical force with abrasive particles. However, the role of CMP is not only material removal, but also planarization, surface smoothening, uniformity control, defect reduction and more. Semiconductor yield enhancement is thus influenced by CMP processing. Surface scratching, which can be generated by CMP, is an extremely detrimental defect in semiconductor manufacturing. Hence, to achieve proper CMP performance without surface scratching, development of polishing compositions is crucially important. Requirements for CMP include planarized surfaces with planarity < 15 nm, roughness- free surfaces with surface roughness < 1 nm, defect-free surfaces with scratch and pit counts of 0 counts per wafer, are contamination-free, have a high productivity, and are planarized with a high removal rate of the desired material to be removed.
In polishing compositions for use with silicon oxide-containing substrates (e.g., TEOS-containing substrates), one key performance metric is a high silicon oxide removal rate (e.g., TEOS removal rate). Polishing compositions with high TEOS removal are ideally formulated at pH greater than 9.5. In addition, high Ta and/or Cu removal rates are observed. More importantly however, these polishing compositions also exhibit good composition stability throughout the testing period.
Thus, key aspects of the polishing compositions described herein include, but are not limited to: 1) a high removal rate for silicon oxide (e.g., TEOS), Ta, and/or Cu; 2) a specified pH to keep the zeta potentials of the various components with the desired polarity, thereby promoting high removal rates; and 3) stability of the polishing composition.

1. Abrasive

The polishing composition described herein contains an abrasive. The abrasive is typically a metal oxide abrasive preferably selected from the group consisting of silica, alumina, titania, zirconia, germania, ceria and mixtures thereof. In some embodiments, the abrasive is silica. In a further embodiment, the abrasive is colloidal silica. In some embodiments, the abrasive is colloidal silica, which is not surface-modified.
In some embodiments, the abrasive is either a commercial product or a synthetic product. As a method for producing colloidal silica, for example, a sodium silicate method and a sol-gel method can be exemplified, and colloidal silica produced by either method can be used preferably as the abrasive of the present invention. However, in the light of reducing metal impurities, colloidal silica produced by the sol-gel method, which can produce colloidal silica at high purity, is more preferable.
The abrasives can have any suitable particle size. In some embodiments, the abrasives used in the present invention have an average primary particle size of 10 nm or more and 100 nm or less. In some embodiments, the abrasives used in the present invention have an average primary particles size of from about 10 nm to about 100 nm, from about 15 nm to about 90 nm, from about 20 nm to about 80 nm, from about 30 nm to about 75 nm, from about 35 nm to about 75 nm, from about 40 nm to about 75 nm, from about 45 nm to about 75 nm, from about 50 nm to about 75 nm, or from about 55 nm to about 75 nm. In some embodiments, the abrasives used in the present invention have an average primary particle size of from about 30 nm to about 80 nm, from about 40 nm to about 70 nm, from about 55 nm to about 75 nm, or from about 60 nm to about 70 nm. In some embodiments, the abrasives used in the present invention have an average primary particle size of from about 10 nm to about 50 nm, from about 20 nm to about 40 nm, from about 25 nm to about 40 nm, from about 30 nm to about 40 nm, or from about 35 nm to about 40 nm. A lower limit of the average primary particle size of the abrasives is preferably 12 nm or more, 23 nm or more, 35 nm or more, 50 nm or more, 60 nm or more, or 65 nm or more. Further, an

upper limit of the average primary particle size of the abrasives is preferably less than 90 nm, less than 80 nm, less than 70 nm, less than 66 nm, less than 50 nm, less than 40 nm or less than 37 nm.

The average primary particle sizes of the abrasives may be measured by an FESEM (field emission scanning electron microscope).

The abrasives can have any suitable secondary particle size. For example, the abrasives can have a secondary particle size of from about 50 nm to about 130 nm, from about 80 nm to about 130 nm, from about 100 nm to about 130 nm, or from about 105 nm to about 130 nm. In some embodiments, the abrasives can have a secondary particle size of from about 110 nm to about 125 nm. In some embodiments, the abrasives can have a secondary particle size of from about 15 nm to about 75 nm, from about 35 nm to about 75 nm, from about 45 nm to about 70 nm, or from about 50 nm to about 65 nm. In some embodiments, the abrasives can have a secondary particle size of about 25 nm or more, about 50 nm or more, about 70 nm or more, about 80 nm or more, about 90 nm or more, about 100 nm or more, or about 110 nm or more. Alternatively, or in addition, the abrasives can have a secondary particle size of about 130 nm or less, about 120 nm or less, about 110 nm or less, about 100 nm or less, about 90 nm or less, about 80 nm or less, about 70 nm or less, or about 65nm or less.

In some embodiments, the abrasives disclosed have a ratio of secondary particle size to primary particle size ranging from about 1.2 to about 2.5, from about 1.3 to about 2.3, from about 1.4 to about 2.1, from about 1.5 to about 2.0, from about 1.6 to about 2.0, or from about 1.7 to about 2.0. In some embodiments, the ratio of secondary particle size to primary particle size is from about 1.65 to about 1.95. In some embodiments, the ratio of secondary particle size to primary particle size is about 1.7. In some embodiments, the ratio of secondary particle size to primary particle size is about 1.9. In some embodiments, the ratio of secondary particle size to primary particle is less than about 2.3, less than about 2.1, less than about 2.0, less than about 1.9, less than about 1.8, less than about 1.7, or less than about 1.6. Alternatively, or in addition, the ratio of secondary particle size to primary particle size is about 1.5 or more, about 1.6 or more, about 1.7 or more, about 1.8 or more, or about 1.9 or more.

The abrasives can have any suitable average mean (D50) particle size. For example, the abrasives can have an average mean (D50) particle size of from about 10 nm to about 200 nm, from about 20 nm to about 180 nm, from about 30 nm to about 170 nm, from about 40 nm to about 160 nm, from about 50 nm to about 150 nm, from about 50 nm to about 140 nm, from about 55 nm to about 130 nm, from about 60 nm to about 130 nm, from about 70 nm to about 130 nm, from about 80 nm to about 130 nm, from about 90 nm to about 130 nm, from about 100 nm to about 130 nm, from about 105 nm to about 130 nm, or from about 105 nm to about 125 nm. In some embodiments, the abrasives can have an average mean (D50) particle size of about 30 nm or more, about 45 nm or more, about 55 or more, or about 58 nm or more. Alternatively, or in addition, the abrasives can have an average mean (D50) particle size of about 100 nm or less, about 80 nm or less, about 70 nm or less, about 60 nm or less, or about 58 nm or less.

A particle size analyzer (such as a Horiba Particle Size Distribution tool) can measure the average mean particle size of the abrasives.

The abrasives can have any suitable particle size distribution. For example, the abrasives can have a D10 value of from about 10 nm to about 100 nm, about 15 nm to about 90 nm, about 20 nm to about 85 nm, or from about 30 nm to about 80 nm. In some embodiments, the abrasives can have a D10 value of from about 10 nm to about 100 nm, from about 35 nm to about 100 nm, from about 50 nm to about 100 nm, from about 55 nm to about 95 nm, from about 60 nm to about 90 nm, from about 65 nm to about 85 nm, or from about 70 nm to about 80 nm. In some embodiments, the abrasives can have a D10 value of from about 10 nm to about 50 nm, from about 20 nm to about 45 nm, from about 25 nm to about 40 nm, or from about 30 nm to about 40 nm.

In some embodiments, the abrasives can have a D90 value of from about 50 nm to about 250 nm, from about 80 nm to about 200 nm, from about 80 nm to about 150 nm, from about 85 nm to about 120 nm, from about 90 to about 120 nm, or from about 95 nm to about 110 nm. In some embodiments, the abrasives can have a D90 value of from about 100 nm to about 300 nm, from about 150 nm to about 250 nm, from about 180 nm to about 240 nm, from about 190 nm to about 230 nm, from about 195 nm to about 225 nm, or from about 200 nm to about 220 nm.

The D90/D50 ratio of the abrasives can vary. In some embodiments, the abrasives can have a D90/D50 ratio of at least about 1.2, at least about 1.4, at least about 1.6, or at least about 1.7. Alternatively, or in addition, the abrasives can have a D90/D50 ratio of about 4.0 or less, about 3.8 or less, about 3.6 or less, about 3.2 or less, about 3.1 or less, about 2.5 or less, about 2.0 or less, or about 1.9 or less. In some embodiments, the D90/D50 ratio of the abrasives ranges from about 1.0 to about 2.0, from about 1.5 to about 2.0, or from about 1.6 to about 1.8.

The D90/D10 ratio of the abrasives can vary. In some embodiments, the abrasives can have a D90/D10 ratio of at least about 1.0, at least about 2.0, at least about 2.5, at least about 2.8, at least about 2.9, or at least about 3.0. Alternatively, or in addition, the abrasives can have a D90/D10 ratio of about 3.5 or less, about 3.3 or less, about 3.2 or less, about 3.1 or less, about 3.0 or less, or about 2.9 or less. In some embodiments, the D90/D10 ratio of the abrasives ranges from about 1.0 to about 4.0, from about 2.0 to about 3.75, from about 2.8 to about 3.5, from about 2.8 to about 3.2, or from 2.8 to about 3.1.

The abrasive can have any suitable surface area. For example, the abrasive can have an average BET surface

area of about 5 $m^2$/g or more, about 10 $m^2$/g or more, about 15 $m^2$/g or more, about 20 $m^2$/g or more, about 25 $m^2$/g or more, about 30 $m^2$/g or more, about 35 $m^2$/g or more, about 40 $m^2$/g or more, about 45 $m^2$/g or more, about 50 $m^2$/g or more, about 55 $m^2$/g or more, about 60 $m^2$/g or more, about 65 $m^2$/g or more, about 70 $m^2$/g or more, about 75 $m^2$/g or more, about 80 $m^2$/g or more, or about 85 $m^2$/g or more. Alternatively, or in addition, the abrasive can have an average BET surface area of about 120 $m^2$/g or less, about 100 $m^2$/g or less, about 80 $m^2$/g or less, about 70 $m^2$/g or less, about 60 $m^2$/g or less, about 55 $m^2$/g or less, about 50 $m^2$/g or less, about 45 $m^2$/g or less, or 40 $m^2$/g or less. In some embodiments, the abrasive can have an average BET surface area in a range from about 5 m2/g to about 100 m2/g, from about 10 m2/g to about 90 m2/g, from about 15 m2/g to about 80 m2/g, from about 20 m2/g to about 70 m2/g, from about 25 $m^2$/g to about 60 $m^2$/g, from about 30 $m^2$/g to about 50 $m^2$/g, or from about 35 $m^2$/g to about 45 $m^2$/g.

The silanol group density on the silica surface of the abrasive can vary. In some embodiments, the abrasive can have an average BET surface area in a range from about 10 $m^2$/g to about 150 $m^2$/g, from about 20 $m^2$/g to about 150 $m^2$/g, from about 30 $m^2$/g to about 150 $m^2$/g, from about 40 $m^2$/g to about 140 $m^2$/g, from about 50 $m^2$/g to about 130 $m^2$/g, from about 60 $m^2$/g to about 120 $m^2$/g, from about 70 $m^2$/g to about 110 $m^2$/g, from about 80 $m^2$/g to about 100 $m^2$/g, or from about 85 $m^2$/g to about 95 $m^2$/g.

The silanol group density on the silica surface of the abrasive can vary. In some embodiments, the average silanol group density on the silica surface of the abrasives contained in the polishing composition of the present invention is 6.0 $nm^{-2}$ or less. If the average silanol group density is more than 6.0 $nm^{-2}$, hardness of the abrasives is low, and the polishing speed is accordingly lowered.

The average silanol group density on the surface of the abrasives is preferably 5.9 $nm^{-2}$ or less, or is more preferably 5.8 $nm^{-2}$ or less. In some embodiments, the average silanol group density on the surface of the abrasives is 5.9 $nm^{-2}$. In some embodiments, the average silanol group density on the surface of the abrasives is 5.8 $nm^{-2}$.

In some embodiments, the average silanol group density on the surface of the abrasives is from about 1.0 $nm^{-2}$ to about 6.0 $nm^{-2}$ , from about 2.0 $nm^{-2}$ to about 6.0 $nm^{-2}$ , from about 3.0 $nm^{-2}$ to about 6.0 $nm^{-2}$ , from about 4.0 $nm^{-2}$ to about 6.0 $nm^{-2}$ , from about 5.0 $nm^{-2}$ to about 6.0 $nm^{-2}$, from about 5.5 $nm^{-2}$ to about 6.0 $nm^{-2}$ , from about 5.7 $nm^{-2}$ to about 6.0 $nm^{-2}$, or from about 5.75 $nm^{-2}$ to about 5.95 $nm^{-2}$.

A lower limit of the average silanol group density is 0.

The number of silanol groups per unit surface area of the abrasives can be calculated by the Sears method using neutralization titration described in "Determination of Specific Surface Area of Colloidal Silica by Titration with Sodium Hydroxide," Analytical Chemistry, 1956, 28(12), pp. 1982-1983, by G. W. Sears. The calculation formula for the number of silanol groups is calculated by the following equation.

$$\rho = ( c \times a \times N_A ) / ( C \times S )$$

ρ: Number of silanol groups [count/$nm^2$]
c: Concentration of sodium hydrate solution used in titration [mol/L]
a: Amount of sodium hydrate solution having pH of 4 to 9 added dropwise [ml]
$N_A$: Avogadro's number ($6.022 \times 10^{23}$ [count/mol])
C: Mass of silica [g]
S: BET specific surface area [$nm^2$/g]

The number of silanol groups per unit surface area of the abrasives can be controlled by selection of the method for producing abrasives or the like.

Moreover, the abrasives may be surface-modified as long as their average silanol group density is within the above-described range. In particular, colloidal silica with organic acid immobilized thereto is preferable. Such immobilization of the organic acid to surfaces of the colloidal silica contained in the polishing composition is made by, for example, chemically bonding functional groups of the organic acid with the surfaces of the colloidal silica. The organic acid is not immobilized to the colloidal silica just by allowing the colloidal silica and the organic acid to coexist. If immobilizing sulfonic acid that is a kind of such organic acid to the colloidal silica, for example, a method described in "Sulfonic acid-functionalized silica through quantitative oxidation of thiol groups," Chem. Commun., 2003, 2, pp. 246-247, can be adopted. More specifically, by coupling a silane coupling agent having thiol groups such as 3-mercaptopropyltrimethoxysilane with the colloidal silica, and subsequently oxidizing the thiol groups with hydrogen peroxide, the colloidal silica with the sulfonic acid immobilized to its surface can be obtained. Alternatively, if immobilizing carboxylic acid to the colloidal silica, for example, a method described in "Novel Silane Coupling Agents Containing a Photolabile 2-Nitrobenzyl Ester for Introduction of a Carboxy Group on the Surface of Silica Gel," Chemistry Letters, 2000, 29(3), pp. 228-229, can be adopted. More specifically, by coupling a silane coupling agent containing photolabile 2-nitrobenzyl ester with the colloidal silica and subsequently irradiating the colloidal silica with light, the colloidal silica with carboxylic acid immobilized to its surface can be obtained.

As described herein, the abrasives used in the Working Examples and Comparative Examples are sulfonic acid surface-modified or not surface modified. In some embodiments, the abrasives are not surface-modified.

In an embodiment, the abrasive has a negative zeta potential. In still further embodiments, the abrasive is silica with a negative zeta potential when in the polishing composition. The negative zeta potential may be in the range from about -60 mV to about 0 mV, from about -58 mV to about -5 mV, from about -55 mV to about -10 mV, from about -53 mV to about -20 mV, from about -50 mV to about -30 mV, or from about -50 mV to about -35 mV. In some embodiments, the negative zeta potential of the abrasives disclosed herein is about -35 mV, -37mV, -38 mV, -39mV, -40mV, -42 mV, -44 mV, -46 mV, -48mV or about -50 mV.

The aspect ratio of the s of the abrasive can vary. In some embodiments, the s of the abrasive can have an aspect ratio of at least about 1.0, at least about 1.1, at least about 1.2, at least about 1.3, at least about 1.4, at least about 1.5, or at least about 1.6. Alternatively, or in addition, the s of the abrasive can have an aspect ratio of about 1.8 or less, about 1.7 or less, about 1.6 or less, about 1.5 or less, about 1.4 or less, about 1.3 or less, about 1.2 or less, or about 1.1 or less. The aspect ratio is an average of values obtained by taking the smallest rectangle circumscribing the image of the abrasive particles by a scanning electron microscope and dividing the length of the long side of the rectangle by the length of the short side of the same rectangle, which can be obtained using general image analysis software.

The amount of abrasive present in the disclosed polishing composition can vary. In some embodiments, the abrasive is present in the polishing composition in a concentration of about 0.01 wt% or more, about 0.05 wt% or more, about 0.1 wt% or more, about 0.2 wt% or more, about 0.25 wt% or more, about 0.5 wt% or more, about 0.75 wt% or more, about 1 wt% or more, about 1.3 wt% or more, about 1.5 wt% or more, about 1.75 wt% or more, about 2.0 wt% or more, about 2.5 wt% or more, or about 3 wt% or more. Alternatively, or in addition, the concentration of the abrasive in the polishing composition can be about 3 wt% or less, about 2.5 wt% or less, about 2.3 wt% or less, about 2.0 wt% or less, about 1.5 wt% or less, about 0.75 wt% or less, about 0.5 wt% or less, about 0.25 wt% or less, about 0.1 wt% or less, about 0.05 wt% or less, about 0.01 wt% or less, or about 0.005 wt% or less. In some embodiments, the concentration of abrasive in the polishing composition can be in a range from about 0.1 wt% to about 3 wt%, about 0.5 wt% to about 3 wt%, from about 1.0 wt% to about 3.5 wt%, from about 1.5 wt% to about 3.0 wt%, from about 1.5 wt% to about 2.5 wt%, or from about 1.75 wt% to about 2.25 wt%.

In some embodiments, the concentration of the abrasive has an effect on the properties of the polishing composition, such as TEOS RR, Ta RR, and/or Cu RR. In an embodiment, the concentration of the abrasive is from about 1.0 wt% to about 3.5 wt%, from about 1.1 wt% to about 3.0 wt%, or from about 1.3 wt% to about 2.5 wt%. In an embodiment, the concentration of the abrasive is about 2.0 wt% with respect to the entire composition.

While the abrasive can be of any reasonable size, the size of the abrasive influences the smoothness of the finish obtained. Precision polishing operations materials such as optical components, plastics, metals, gemstones, semiconductor components and the like typically involve the use of abrasives with smaller sizes. For example, compositions for use in connection with precision polishing involve suspensions of abrasives with smaller average particle sizes.

In an embodiment the abrasive is colloidal silica. In some embodiments, the abrasive substantially comprises colloidal silica. As used herein, "substantially" means that 95 wt% or more, preferably 98 wt% or more, more preferably 99 wt% or more of the particles constituting the abrasive are colloidal silica, and it includes that 100 wt% of the particles are colloidal silica.

The abrasive is suspended in the compositions disclosed herein and is colloidally stable. The term colloid refers to the suspension of abrasive particles in the liquid carrier. Colloidal stability refers to the maintenance of the suspension over time. In some embodiments, the suspension is stable for at least 1, 2, 3, 4, 5, 6, or 7 days. In some embodiments, the suspension is stable for at least 1 week, at least 2 weeks, at least 3 weeks, or at least 4 weeks.

In the context of this invention, a polishing composition is considered colloidally stable if, when the silica is placed into a 100-mL graduated cylinder and allowed to stand without agitation for a time of two hours, the difference between the concentration of particles in the bottom 50 mL of the graduated cylinder ([B] in terms of g/mL) and the concentration of particles in the top 50 mL of the graduated cylinder ([T] in terms of g/mL) divided by the total concentration of particles in the polishing composition ([C] in terms of g/mL) is less than or equal to 0.5 (i.e., ([B]-[T])/[C]s0.5). The value of ([B]-[T]/[C]) desirably is less than or equal to 0.3, and preferably is less than or equal to 0.1.

2. Oxidizer

The oxidizer added to the polishing composition has an action of oxidizing the surface of the polishing object and improves the polishing speed of the polishing object by the polishing composition. In some embodiments, the oxidizer is a peroxide. Exemplary peroxides include hydrogen peroxide, sodium peroxide, barium peroxide, and salt thereof. In some embodiments, the oxidizer is hydrogen peroxide.

Additional examples of other oxidizers include, but are not limited to, ozone water, a silver (II) salt, permanganic acid, chromic acid, dichromic acid, peroxodisulfuric acid, peroxophosphoric acid, peroxosulfuric acid, peroxoboric acid, performic acid, peracetic acid, perbenzoic acid, perphthalic acid, hypochlorous acid, hypobromous acid, hypoiodous acid,

chloric acid, chlorous acid, perchloric acid, bromic acid, iodic acid, periodic acid, persulfuric acid, dichloroisocyanuric acid, and salts thereof. In another embodiment, other oxidizers may include an amine oxide compound. Non-limiting examples of amine oxide compounds include, but are not limited to, N-methylmorpholine N-oxide, myristamine oxide, lauamine oxide, decylamine oxide, bis (2-dimethylaminoethyl) ether, N, N-dimethyllaurylamine oxide. These oxidants may be used either singly or in mixture of two or more kinds thereof.

In some embodiments, the concentration of oxidizer has an effect on the properties of the polishing composition, such as removal rates for TEOS, Ta, and/or Cu. The oxidizer can be present at a concentration ranging from about 0.1 wt% to about 10 wt%, from about 0.25 wt% to about 7.5 wt%, from about 0.3 wt% to about 3 wt%, from about 0.5 wt% to about 2.5 wt%, from about 0.5 wt% to about 2 wt%, from about 0.5 wt% to about 1.5 wt%, from about 0.8 wt% to about 1.25 wt%, or from about 0.8 wt% to about 1.20 wt%. In some embodiments, the concentration of the oxidizer may range from about 0.001 wt% to about 2 wt%, from about 0.01 wt% to about 2 wt%, from about 0.01 wt% to about 1.5 wt%, from about 0.1 wt% to about 1.5 wt%, from about 0.5 wt% to about 1.5 wt%, from about 0.75 wt% to about 1.25 wt%, or about 1.0 wt%. In some embodiments, the oxidizer is present in a concentration of about 0.01 wt% or more, about 0.1 wt% or more, about 0.2 wt% or more, about 0.3 wt% or more, about 0.4 wt% or more, about 0.5 wt% or more, or about 0.6 wt% or more. Alternatively, or in addition, the amount of oxidizer is about 5.0 wt% or less, about 3.50 wt% or less, about 2.0 wt% or less, about 1.50 wt% or less, about 1.25 wt% or less, about 1.0 wt% or less, about 0.5 wt% or less, or about 0.1 wt% or less.

The percentage of oxidizer is measured with respect to the entire composition. Further, the percentage of oxidizer is measured as a Point Of Use (POU) composition. As used herein, the term "point of use" refers to a composition that is prepared and to be used in proximity to the polishing machine that supplies the polishing composition to an individual polishing machine for use in the CMP process.

3. Silicon Oxide Removal Rate Controller

In one aspect, the polishing composition may contain a silicon oxide removal rate controller. Such a silicon oxide removal rate controller can be any agent, but the silicon oxide removal rate controller is a zwitterion. As used herein, the zwitterion is characterized by having two distinct and opposite charges on the molecule at either adjacent or non-adjacent sites.

Further, the silicon oxide removal rate controller preferably exhibits a certain pKa. Thus, in some embodiments, the silicon oxide removal rate controller disclosed herein has a pKa of from about 7 to about 11, from about 7.5 to about 11, from about 8 to about 11, from about 8.5 to about 11, from about 9 to about 11, from about 9.5 to about 11, from about 9.6 to about 11, from about 10 to about 11, or from about 10.4 to about 11, at 25°C. In some embodiments, the silicon oxide removal rate controller has a pKa of from about 7.5 to about 11.0, from about 8.0 to about 11.0, from about 8.5 to about 11.0, from about 9.0 to about 11.0, from about 9.5 to about 11.0, or from about 9.5 to about 10.5, at 25°C. In some embodiments, the silicon oxide removal rate controller has a pKa of at least about 7, at least about 8, at least about 9, at least about 9.4, at least about 9.5, or at least about 9.7, at 25°C. Alternatively, or in addition to, the silicon oxide removal rate controller has a pKa that is no more than about 11, no more than about 10.9, no more than about 10.8, no more than about 10.7, no more than about 10.5, no more than about 10.4, no more than about 10, no more than about 9.6, no more than about 9.5, or no more than about 9.4, at 25°C.

In some embodiments, the above-mentioned pKa is at room temperature (i.e., between 20 °C and 25 °C). In some embodiments, the above-mentioned pKa is at elevated temperatures (i.e., at about 40 °C).

The silicon oxide removal rate controller is a zwitterion. In some embodiments, the zwitterion is a sulfonated zwitterion. In some embodiments, the zwitterion is a primary, secondary or tertiary amine with a sulfo group ($-SO_3H$). In some embodiments, the zwitterion is a secondary amine with a sulfo group ($-SO_3H$) or a tertiary amine with a sulfo group ($-SO_3H$). In some embodiments, the zwitterion is a compound having an aminoalkyl sulfo group ($-NH-R^1-SO_3H$; $R^1$ is a substituted or unsubstituted alkylene group having 1 to 6 carbon atoms). Herein, in $NH-R^1-SO_3H$, $R^1$ has preferably 1 to 4 carbon atoms, and more preferably 1 to 3 carbon atoms. The substituent substituting the alkylene group is preferably a hydroxy group.

In some embodiments, the silicon oxide removal rate controller is a secondary amine having a sulfo group ($-SO_3H$) or a tertiary amine having a sulfo group ($-SO_3H$) with a pKa of from about 8.0 to about 11.0 (preferably from about 9.5 to about 11.0), at 25°C. In some embodiments, the silicon oxide removal rate controller is a compound having an aminoalkyl sulfo group ($-NH-R^1-SO_3H$; $R^1$ is a substituted or unsubstituted alkylene group having 1 to 6 carbon atoms) with a pKa of from about 8.0 to about 11.0 (preferably from about 9.5 to about 11.0), at 25°C.

In some embodiments, the silicon oxide removal rate controller is a compound represented by the following formula (a-1) or (a-2):

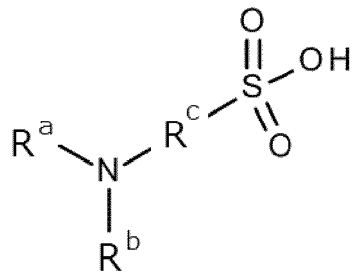

(a-1)

wherein

$R^a$ and $R^b$ are each independently hydrogen, a substituted $(C_1-C_6)$ alkyl group or an unsubstituted $(C_1-C_6)$ alkyl group, where $R^a$ and $R^b$ may be bonded to each other to form a ring (excluding a piperazine ring); and

$R^c$ is a single bond, a substituted $(C_1-C_6)$ alkylene group or an unsubstituted $(C_1-C_6)$ alkylene group, or

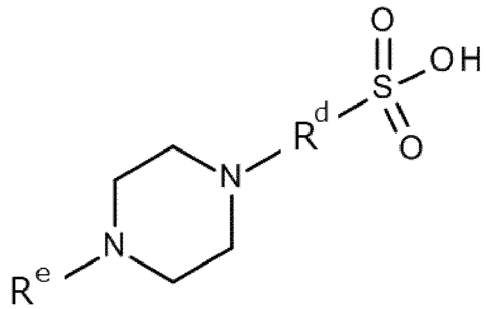

(a-2)

wherein

$R^d$ is a single bond, a substituted $(C_1-C_6)$ alkylene group, or an unsubstituted $(C_1-C_6)$ alkylene group; and $R^e$ is hydrogen, a substituted $(C_1-C_6)$ alkyl group, an unsubstituted $(C_1-C_6)$ alkyl group, or - $R^f$-$SO_3H$, where $R^f$ is a single bond, a substituted $(C_1-C_6)$ alkylene group, or an unsubstituted $(C_1-C_6)$ alkylene group.

Here, the $(C_1-C_6)$ alkyl groups in $R^a$, $R^b$, and $R^e$ represent linear, branched, or cyclic alkyl groups having 1 to 6 carbon atoms. Examples of $(C_1-C_6)$ alkyl include methyl, ethyl, n-propyl, isopropyl, n-butyl, sec-butyl, isobutyl, tert-butyl, n-pentyl, isopentyl, neopentyl, n-hexyl, and cyclohexyl. When $R^a$ and $R^b$ are bonded to each other to form a ring, the ring-forming atom may contain nitrogen (in this case, $R^a$ or $R^b$ is a substituted $(C_1-C_6)$ alkyl having an amino group as a substituent, and the nitrogen atom of the amino group is substituted to form a ring-forming atom). When $R^a$ and $R^b$ are bonded to each other to form a ring, examples of the ring to be formed include 5- to 6-membered ring compounds excluding a piperazine ring, such as a pyrrolidine ring, an imidazolidine ring, a pyrazolidine, and a piperidine ring.

The $(C_1-C_6)$ alkylene groups in $R^c$, $R^d$, and $R^f$ represent linear, branched, or cyclic alkylene groups having 1 to 6 carbon atoms. Examples of $(C_1-C_6)$ alkylene include methylene, ethylene, n-propylene, isopropylene, n-butylene, sec-butylene, isobutylene, tert-butylene, n-pentylene, isopentylene, neopentylene, n-hexyl, and cyclohexylene.

As substituents when groups are substituted in $R^a$ to $R^f$, the groups described in the description of the term "substituted" above can be applied. Among them, the substituent in $R^a$ to $R^f$ is preferably a hydroxy group, a halogen group, an amino group, a mercapto group, a $(C_1-C_6)$ alkylthiol group, a $(C_1-C_6)$ alkoxy group, and the like, and more preferably a hydroxy group, a halogen group, and an amino group.

In some embodiments, the silicon oxide removal rate controller is a compound of Formula (I):

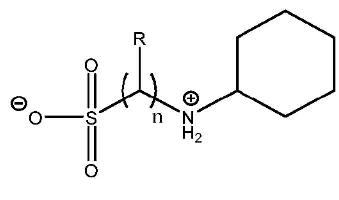

Formula (I)

wherein n is an integer selected from 1-10; and
R is selected, in each instance, from the group consisting of -H, -OH, $-NH_2$, -COOH, substituted ($C_1$-$C_6$) alkyl, and unsubstituted ($C_1$-$C_6$) alkyl.

In some embodiments, the silicon oxide removal rate controller is a compound of Formula (I), wherein n is an integer selected from 2, 3, and 4.

In some embodiments, the silicon oxide removal rate controller is a compound of Formula (I), wherein R in each instance is -H.

In some embodiments, the silicon oxide removal rate controller is a compound of Formula (I), wherein n is an integer selected from 2, 3, and 4; and R, in each instance is -H.

In some embodiments, the silicon oxide removal rate controller is a compound of Formula (I), wherein n is an integer selected from 2, 3, and 4; and R, in one instance is -OH.

In some embodiments, the silicon oxide removal rate controller is selected from the group consisting ofN-cyclohexyl-3-aminopropanesulfonic acid (CAPS), 4-(cyclohexylamino)butane-1-sulfonic acid (CABS), 3-(cyclohexylamino)-2-hydroxy-1-propanesulfonic acid (CAPSO), N-cyclohexyl-2-aminoethanesulfonic acid (CHES), N-[tris(hydroxymethyl)methyl]-3-aminopropanesulfonic acid (TAPS), piperazine-1,4-bis(2-hydroxypropanesulfonic acid) (POPSO), 2-[4-(2-hydroxyethyl)-1-piperazinyl]-ethanesulfonic acid (HEPES), and a combination thereof.

In some embodiments, the silicon oxide removal rate controller is selected from the group consisting ofN-cyclohexyl-3-aminopropanesulfonic acid (CAPS), 4-(cyclohexylamino)butane-1-sulfonic acid (CABS), 3-(cyclohexylamino)-2-hydroxy-1-propanesulfonic acid (CAPSO), N-cyclohexyl-2-aminoethanesulfonic acid (CHES), and a combination thereof. In some embodiments, the silicon oxide removal rate controller is N-cyclohexyl-3-aminopropanesulfonic acid (CAPS).

In some embodiments, the silicon oxide removal rate controller is present in the polishing composition at a concentration ranging of from about 0.01 wt% to about 1.5 wt%, about 0.01 wt% to about 1.25 wt%, from about 0.01 wt% to about 1.0 wt%, from about 0.01 wt% to about 0.75 wt%, from about 0.01 wt% to about 0.5 wt%, from about 0.1 wt% to about 0.5 wt%, or from about 0.1 wt% to about 0.3 wt%, based on the total amount of the polishing composition as 100 wt%. In some embodiments, the silicon oxide removal rate controller is present in the polishing composition at a concentration of about 0.01 wt% or more, about 0.02 wt% or more, about 0.04 wt% or more, about 0.06 wt% or more, about 0.08 wt% or more, about 0.1 wt% or more, about 0.12 wt% or more, about 0.14 wt% or more, about 0.16 wt% or more, about 0.18 wt% or more, about 0.2 wt% or more, about 0.5 wt% or more, or about 0.8 wt% or more. Alternatively, or in addition, the concentration of silicon oxide removal rate controller in the polishing composition can be about 2.0 wt% or less, about 1.5 wt% or less, about 1.2 wt% or less, about 1.0 wt% or less, about 0.75 wt% or less, about 0.5 wt% or less, about 0.30 wt% or less, about 0.25 wt% or less, about 0.2 wt% or less, about 0.1 wt% or less or about 0.05 wt% or less. In some embodiments, the concentration of silicon oxide removal rate controller is from about 0.01 wt% to about 1.00 wt%, from about 0.05 wt% to about 0.50 wt%, or about 0.2 wt%.

### 4. Base Compound

In one aspect, the polishing compositions may comprise a base compound. In some embodiments, the base compound is an inorganic base. A non-limiting example of an inorganic base is an alkali metal hydroxide. In some embodiments, the inorganic base is selected from the group consisting of sodium hydroxide, potassium hydroxide, cesium hydroxide and a combination thereof. In some embodiments, the inorganic base is potassium hydroxide.

The base compound may be present at a specific concentration range. For example, in some embodiments, the amount of base compound is in a range from about 0.01 wt% to about 2.0 wt%, from about 0.1 wt% to about 1.0 wt%, from about 0.1 wt% to about 0.8 wt%, from about 0.1 wt% to about 0.6 wt%, from about 0.2 wt% to about 0.5wt%, or from about 0.3 wt% to about 0.4 wt%. In some embodiments, the amount of base compound is less than about 1.0 wt%, less than about 0.8 wt%, less than about 0.6 wt%, less than about 0.5 wt%, less than about 0.4 wt%, less than about 0.3 wt%, or less than about 0.2 wt%. In some embodiments, the amount of base compound is at least about 0.05 wt% or more, at least about 0.1 wt% or more, at least about 0.2 wt% or more, at least about 0.3 wt% or more, at least about 0.4 wt% or more, or at least 0.5 wt% or more.

### 5. Acid Component (Acid Compound)

In one aspect, the polishing composition may contain an acid component (also referred to as an "acid compound"). The acid in the acid component is not particularly limited as long as it exhibits the desired acidity. In some embodiments, the acid component is an organic acid. In some embodiments, the organic acid is selected from the group consisting of citric acid, nitric acid, phosphoric acid, maleic acid, tartaric acid, 1-hydroxyethylidene-1,1-diphosphonic acid (HEDP), glycolic acid, lactic acid, malic acid, hydroxybutyric acid, and a combination thereof. In some embodiments, the organic acid is citric acid.

The amount of acid component present in the polishing composition can vary. In some embodiments, the acid component is present in the polishing composition in an amount of from about 0.01 wt% to about 1 wt%, from about 0.02 wt% to about 0.75 wt%, from about 0.05 wt% to about 0.5 wt%, from about 0.15 wt% to about 0.2 wt%, or about 0.1 wt%. In some embodiments, the amount of acid component present in the polishing composition of at least about 0.001 wt%, at least about 0.01 wt%, at least about 0.05 wt%, at least about 0.1 wt%, at least about 0.15 wt%, or at least about 0.2 wt%. In some embodiments, the acid component is present in an amount of less than about 1 wt%, less than about 0.5 wt%, less than about 0.4 wt%, less than about 0.3 wt%, less than about 0.25 wt%, less than about 0.2 wt%, or less than about 0.15 wt%. In some embodiments, the acid component is present in the polishing composition in an amount of 0.1 wt%.

6. pH -Adjusting Agent

The polishing compositions of this disclosure optionally contain at least one pH adjusting agent to control the pH. In an embodiment, the pH-adjusting agent is a basic compound. The basic compound may be appropriately selected from various basic compounds that have a function of raising the pH of polishing compositions in which the compounds are dissolved. For example, an inorganic basic compound such as an alkali metal hydroxide, an alkaline earth metal hydroxide, various carbonates, bicarbonates and the like may be used. Such basic compounds may be used singly or in combination of two or more types thereof.

Specific examples of the alkali metal hydroxide include potassium hydroxide, sodium hydroxide, ammonium hydroxide, and the like. Specific examples of the carbonate and bicarbonate include ammonium hydrogen carbonate, ammonium carbonate, potassium hydrogen carbonate, potassium carbonate, sodium hydrogen carbonate, sodium carbonate and the like.

In alternate embodiments, the pH-adjusting agent may be acidic in nature. The choice of acid is not particularly limited provided that the strength of the acid is sufficient to lower the pH of the polishing composition of the present invention.

The acidic pH-adjusting agent may be an inorganic acid or an organic acid. For example, and without limitation, such inorganic acids include hydrochloric acid, sulfuric acid, nitric acid, boric acid, carbonic acid, hypophosphorous acid, phosphorous acid, and phosphoric acid.

For example, and without limitation, such organic acids include formic acid, acetic acid, chloroacetic acid, propionic acid, butanoic acid, valeric acid, 2-methylbutyric acid, N-hexanoic acid, 3,3-dimethylbutanoic acid, 2-ethylbutanoic acid, 4-methylpentanoic acid, n-heptanoic acid, 2-methyl hexanoic acid, n-octanoic acid, 2-ethylhexanoic acid, benzoic acid, glycolic acid, salicylic acid, glyceric acid, oxalic acid, malonic acid, succinic acid, glutaric acid, adipic acid, pimelic acid, maleic acid, phthalic acid, malic acid, tartaric acid, citrate, citric acid, lactic acid, diglycolic acid, 2-furancarboxylic acid, 3-furancarboxylic acid, 2-tetrahydro furancarboxylic acid, methoxy acetic acid, methoxyphenyl acetic acid, and phenoxyacetic acid. Such organic acids also include, without limitation, organic sulfonic acid, such as methanesulfonic acid, ethane sulfonic acid, and isethionic acid.

The pH adjusting agent may be a mixture of an acidic agent and basic agent (such as a buffer).

In some embodiments, the pH of the polishing composition is adjusted to a range from about 6.5 to about 12.0, from about 7.5 to about 11.5, from about 8.5 to about 11.0, from about 9.0 to about 11.0, from about 9.5 to about 10.6, from about 9.5 to about 10.5, or from about 9.8 to about 10.2. In some embodiments, the pH is less than about 6, less than about 5, less than about 4, or less than 3. Alternatively, or in addition to, the pH is more than about 7.0, more than about 8.0, more than about 9.2 more than about 9.3, or more than about 9.6. In some embodiments, the pH is about 11.0 or less, about 10.8 or less, about 10.6 or less, about 10.4 or less, about 10.3 or less, about 10.2 or less, or about 10.1 or less. In some embodiments, the pH is about 10.0.

The pH adjusting agent may be present at a specific concentration range, regardless of pH. For example, in some embodiments, the amount of pH adjusting agent is in a range from about 0.0001 wt% to about 1 wt%, from about 0.005 wt% to about 0.5%, or from about 0.001 wt% to about 0.1 wt%. In alternate embodiments, the amount of pH adjusting agent is in a range from about 0.0001 wt% to about 0.0010 wt%, from about 0.0003 wt% to about 0.0009 wt%, or from about 0.0005 wt% to about 0.0008 wt%. In alternate embodiments, the amount of pH adjusting agent is in a range from about 0.0009 wt% to about 0.0040 wt% or from about 0.0010 wt% to about 0.0030 wt%. In still alternate embodiments, the pH adjusting agent is in a range from about 0.001 wt% to about 0.01 wt%. In some embodiments, the amount of pH adjusting agent is present in an amount of at least about 0.0001 wt%, at least about 0.0005 wt%, at least about 0.001 wt%, at least about 0.005 wt%, at least about 0.01 wt%, at least about 0.025 wt%, at least about 0.05 wt%, at least about 0.075 wt%, or at least about 0.1 wt%. In some embodiments, the pH adjusting agent is present in an amount of less than about 0.01 wt%, less than about 0.005 wt%, less than about 0.001 wt%, or less than about 0.0005 wt%. In some embodiments, the pH adjusting agent is present in an amount that is about 0.0001 wt%, about 0.00025 wt%, about 0.0005 wt%, about 0.0006 wt%, about 0.0007 wt%, about 0.0008 wt%, about 0.0009 wt%, about 0.001 wt%, about 0.005 wt%, about 0.0075 wt%, about 0.01 wt%, about 0.025 wt%, or about 0.05 wt%.

Water

In some embodiments, the polishing compositions disclosed herein contain a carrier, medium, or vehicle. In some embodiments, the carrier, medium, or vehicle is water. Ion exchanged water (deionized water), pure water, ultrapure water, distilled water and the like may be used as the water. In order to reduce the amount of unwanted components present in the water, the purity of water may be increased by operations such as removal of impurity ions with an ion exchange resin, removal of contaminants with a filter, and/or distillation.

In some embodiments, the water is relatively free of impurities. In some embodiments, the water contains less than about 10% w/w, about 9% w/w, about 8% w/w, about 7% w/w, about 6% w/w, about 5% w/w, about 4% w/w, about 3% w/w, about 2% w/w, about 1% w/w, about 0.9% w/w, about 0.8% w/w, about 0.7% w/w, about 0.6% w/w, about 0.5% w/w, about 0.4% w/w, about 0.3% w/w, or less than about 0.1% w/w of impurities based on the total weight of the water.

8. Additional Components

In some embodiments, the polishing compositions disclosed herein may contain additional components such as corrosion inhibitors, polysaccharides, chelating agent, biocides, surfactants, or co-solvents. Additionally or alternatively, the compositions disclosed herein can include other additives as will be understood by those skilled in the art.

In another embodiment, the additional component may include a corrosion inhibitor. Non-limiting examples of the corrosion inhibitor may include 2-methyl-3-butyn-2-ol, 3-methyl-2-pyrazolin-5-one, 8-hydroxyquinoline, and dicyandiamide, benzotriazole and its derivatives, pyrazole and its derivatives, imidazole and its derivatives, benzimidazole and its derivatives, isocyanurate and its derivatives, and mixtures thereof. In some embodiments, the polishing composition disclosed herein contain benzotriazole (BTA). In some embodiments, the polishing composition disclosed herein contain 1-methyl benzotriazole or 5-methyl benzotriazole. The concentration of corrosion inhibitor present in the polishing composition may range from about 0.0005 wt% to about 0.25 wt%, from about 0.001 wt% to about 0.25 wt%, from about 0.01 wt% to about 0.25 wt%, from about 0.05 wt% to about 0.20 wt%, from about 0.05 wt% to about 0.15 wt%, or from about 0.07 wt% to about 0.12 wt%. In some embodiments, the concentration of corrosion inhibitor present in the polishing composition may range from about 0.02 wt% to about 0.10 wt% or preferably from about 0.05 wt% to about 0.15 wt% of corrosion inhibitor. In some embodiments, the concentration of corrosion inhibitor present in the polishing composition is 0.10 wt%.

In an alternative embodiment, the polishing composition is corrosion inhibitor agent free. The term "corrosion inhibitor agent free" as used herein means that the polishing composition does not contain compounds known in the art to be used as corrosion inhibitors.

In one embodiment, the carbohydrate is a polysaccharide known as pullulan. The polysaccharide pullulan is comprised of maltotriose units consisting of three $\alpha$-1,4-linked glucose molecules are further linked by $\alpha$-1,6-bonds. In an embodiment, pullulan has a weight average molecular weight ranging from 10,000 to 1,000,000. In some embodiments, the concentration of pullulan is present in the polishing composition in a range from about 0.01 wt% to about 0.05 wt%, such as about 0.02 wt%.

In an alternative embodiment, the polishing composition is carbohydrate free. The term "carbohydrate free" as used herein means that the polishing composition does not contain compounds known in the art as carbohydrates.

In another embodiment, the additional component may include a chelating agent. The term chelating agent is intended to mean any substance that in the presence of an aqueous solution chelates metals, such as copper. Non-limiting examples of chelating agents include inorganic acids, organic acids, amines, and amino acids such as glycine, alanine, citric acid, acetic acid, maleic acid, oxalic acid, malonic acid, phthalic acid, succinic acid, nitrilotriacetic acid, iminodiacetic acid, ethylenediamine, CDTA, and EDTA.

In an alternative embodiment, the polishing composition is chelating agent free. The term "chelating agent free" as used herein means that the polishing composition does not contain compounds known in the art as chelating agents. Non-limiting examples of chelating agents include compounds such as glycine, alanine, citric acid, acetic acid, maleic acid, oxalic acid, malonic acid, phthalic acid, succinic acid, nitrilotriacetic acid, iminodiacetic acid, ethylenediamine, CDTA, and EDTA.

In some embodiments, the additional component may be a biocide. Non-limiting examples of biocides include hydrogen peroxide, quaternary ammonium compounds, and chlorine compounds. More specific examples of the quaternary ammonium compounds include, but are not limited to, methylisothiazolinone, tetramethylammonium chloride, tetraethylammonium chloride, tetrapropylammonium chloride, alkylbenzyldimethylammonium chloride, and alkylbenzyldimethylammonium hydroxide, wherein the alkyl chain ranges from 1 to about 20 carbon atoms. More specific examples of the chlorine compounds include, but are not limited to, sodium chlorite and sodium hypochlorite. Additional examples of biocides include biguanide, aldehydes, ethylene oxide, isothiazolinone, iodophor, KATHON™ and NEOLENE™ product families that are commercially available from Dow chemicals, and the Preventol™ family from Lanxess. The amount of biocide used in the polishing composition may range from about 0.0001 wt% to 0.10 wt%, preferably from 0.0001 wt% to

0.005 wt%, and more preferably from 0.0002 wt% to 0.0025 wt%.

In another embodiment, the additional component may include a surfactant. The surfactants may be anionic, cationic, nonionic, or zwitterionic and may increase lubricity of the vehicle or compositions. Non-limiting examples of the surfactants are dodecyl sulfates, sodium salts or potassium salts, lauryl sulfates, secondary alkane sulfonates, alcohol ethoxylate, acetylenic diol surfactant, quaternary ammonium-based surfactants, amphoteric surfactants, such as betaines and amino acid derivatives-based surfactants, and any combination thereof. Examples of suitable commercially available surfactants include TRITON™, TERGITOL™, DOWFAX™ family of surfactants manufactured by Dow Chemicals and various surfactants in SURFYNOL™, DYNOL™, ZETASPERSE™, NONIDET™, and TOMADOL™ surfactant families, manufactured by Air Products and Chemicals. Suitable surfactants of surfactants may also include polymers comprising ethylene oxide (EO) and propylene oxide (PO) groups. An example of EO-PO polymer is TETRONIC™ 90R4 from BASF Chemicals. An example of acetylenic diol surfactant is DYNOL™ 607 from Air Products and Chemicals. The amount of surfactant used in the polishing composition may range from about 0.0005 wt% to 0.15 wt%, preferably from 0.001 wt% to 0.05 wt%, and more preferably from 0.0025 wt% to 0.025 wt%.

In another embodiment, the additional component may include another solvent, termed a co-solvent. Non-limiting examples of co-solvents include, but are not limited to, alcohol (such as methanol or ethanol), ethyl acetate, tetrahydrofuran, alkanes, tetrahydrofuran, dimethylformamide, toluene, ketones (such as acetone), aldehydes, and esters. Other non-limiting examples of co-solvents include dimethyl formamide, dimethyl sulfoxide, pyridine, acetonitrile, glycols, and mixtures thereof. The co-solvent may be employed in various amounts, preferably from a lower limit of about 0.0001, 0.001, 0.01, 0.1, 0.5, 1, 5, or 10% (wt%) to an upper limit of about 0.001, 0.01, 0.1, 1, 5, 10, 15, 20, 25, or 35% (wt%).

As described herein, the polishing compositions have specific properties, which are greatly influenced by the components in the composition, both in type and amount. Thus, certain materials may need to be excluded from the composition in order to maintain the desired properties.

The polishing composition of the invention can be prepared by any suitable technique, many of which are known to those skilled in the art. The polishing composition can be prepared in a batch or a continuous process. Generally, the polishing composition can be prepared by combining the components disclosed herein in any order. The term "component" as used herein includes individual ingredients (e.g., abrasive, silicon oxide removal rate controller, oxidizer, base component, and the like), as well as any combination of ingredients. For example, the abrasive can be dispersed in water, the silicon oxide removal rate controller, base compound and oxidizer as well as any other additive material can be added, and mixed by any method that is capable of incorporating the components into the polishing composition. The pH can be further adjusted, if desired, at any suitable time by addition of an acid, base or a buffer, as needed.

The polishing compositions described herein have high stability. For example, if the stability testing (MPS Gap after three days) described in the Examples to be described later results in 25 or less, it can be determined that the compositions have high stability. According to some embodiments, the polishing compositions described herein have a stability testing (MPS Gap after three days) described in the Examples to be described later resulting in 20 or less, 15 or less, 10 or less, or 5 or less. Stability testing (MPS Gap after three days) evaluates changes in the mean particle size (MPS) of the abrasives using a Malvern Panalytical ZetaSizer Nano light scattering system. Specifically, the value is obtained by calculating the difference ($MPS^2$ - $MPS^1$ (unit: nm)) between the mean particle size $MPS^1$ immediately after preparation of the composition and the mean particle size $MPS^2$ after storage at 55°C for three days.

Accordingly, the polishing compositions described herein have specific properties exemplified by their performance in silicon oxide removal rate (e.g., TEOS removal rate), Ta removal rate, and/or Cu removal rate.

The polishing compositions described herein are used to polish a polishing object comprising one or more selected from the group consisting of TEOS, tantalum, and copper. According to some embodiments, the polishing compositions described herein are used to polish polishing objects comprising TEOS, tantalum, and/or copper.

For the polishing compositions disclosed herein, the polishing compositions have a silicon oxide removal rate (e.g., TEOS removal rate) of at least ≥ about 60 Å/min; at least ≥ about 70 Å/min; at least ≥ about 74 Å/min; at least ≥ about 80 Å/min; at least ≥ about 85 Å/min; at least ≥ about 90 Å/min; at least ≥ about 95 Å/min; at least ≥ about 100 Å/min; at least ≥ about 105 Å/min; at least ≥ about 110, or at least ≥ about 115 Å/min. In some embodiments, the silicon oxide removal rate (e.g., TEOS removal rate) is in a range of from about 60 Å/min to about 150 Å/min; from about 70 Å/min to about 125 Å/min; from about 79 Å/min to about 120 Å/min; from about 98 Å/min to about 118 Å/min; from about 98 Å/min to about 111 Å/min; or from about 100 Å/min to about 111 Å/min. In some embodiments, the silicon oxide removal rate (e.g., TEOS removal rate) is in a range of from about 95 Å/min to about 130 Å/min; from about 95 Å/min to about 120 Å/min; from about 100 Å/min to about 125 Å/min; from about 105 Å/min to about 120 Å/min; from about 105 Å/min to about 115 Å/min; or from about 110 Å/min to about 115 Å/min.

For the polishing compositions disclosed herein, the polishing compositions have a Ta removal rate of at least ≥ about 75 Å/min; at least ≥ about 85 Å/min; at least ≥ about 95 Å/min; at least ≥ about 105 Å/min; at least ≥ about 110 Å/min; at least ≥ about 115 Å/min; at least ≥ about 120 Å/min; at least ≥ about 125 Å/min; at least ≥ about 130 Å/min; at least ≥ about 135 Å/min; at least ≥ about 140; or at least ≥ about 145 Å/min Å/min. In some embodiments, the Ta removal rate is in a range of from about 75 Å/min to about 200 Å/min; from about 75 Å/min to about 175 Å/min; from about 100 Å/min to about 160

Å/min; from about 115 Å/min to about 160 Å/min; from about 125 Å/min to about 155 Å/min; from about 130 Å/min to about 155 Å/min; from about 135 Å/min to about 155 Å/min; or from about 140 Å/min to about 150 Å/min. In some embodiments, the Ta removal rate is in a range of from about 100 Å/min to about 145 Å/min; from about 105 Å/min to about 135 Å/min; from about 115 Å/min to about 130 Å/min; from about 120 Å/min to about 130 Å/min; or from about 125 Å/min to about 130 Å/min.

For the polishing compositions disclosed herein, the polishing compositions have a Cu removal rate of at least ≥ about 40 Å/min; at least ≥ about 50 Å/min; at least ≥ about 60 Å/min; at least ≥ about 70 Å/min; at least ≥ about 80 Å/min; at least ≥ about 90 Å/min; at least ≥ about 100 Å/min; at least ≥ about 105 Å/min; at least ≥ about 110 Å/min; or at least ≥ about 115 Å/min. In some embodiments, the Cu removal rate is in a range of from about 50 Å/min to about 150 Å/min; from about 70 Å/min to about 141 Å/min; from about 80 Å/min to about 141 Å/min; from about 90 Å/min to about 133 Å/min; from about 100 Å/min to about 130 Å/min; 110 Å/min to about 130 Å/min; or from about 115 Å/min to about 130 Å/min.

Accordingly, as described herein, in some embodiments are polishing compositions comprising an abrasive, a base component, a silicon oxide removal rate controller, and an oxidizer, wherein the abrasive is a silica abrasive with a primary particle size ranging from about 30 nm to about 70 nm and a secondary particle size ranging from about 50 nm to about 130 nm; the base compound is an inorganic base; the silicon oxide removal rate controller has a pKa ranging from about 7 to about 11 at 25°C; and the oxidizer is a peroxide.

As in any embodiment above, the polishing composition comprises an abrasive which is not surface-modified.

As in any embodiment above, the polishing composition comprises an abrasive which has a primary particle size ranging from about 60 nm to about 70 nm.

As in any embodiment above, the polishing composition comprises an abrasive which has a secondary particle size ranging from about 105 nm to about 125 nm.

As in any embodiment above, the polishing composition comprises an abrasive which has a ratio of secondary particle size to primary particle size ranging from about 1.5 to about 2.0 (preferably, from about 1.6 to about 2.0, more preferably, from about 1.7 to about 2.0).

As in any embodiment above, the polishing composition comprises an abrasive which has a D90/D50 ratio ranging from about 1.6 to about 1.8.

As in any embodiment above, the polishing composition comprises an abrasive which has a D90/D10 ratio ranging from about 2.8 to about 3. 1.

As in any embodiment above, the polishing composition comprises an abrasive which has a D90 of from about 100 nm to about 220 nm.

As in any embodiment above, the polishing composition comprises an abrasive which has a D10 of from about 30 nm to about 75 nm.

As in any embodiment above, the polishing composition comprises an abrasive which has a D50 of from about 55 nm to about 60 nm.

As in any embodiment above, the polishing composition comprises an abrasive present at a concentration of from about 0.1 wt% to about 3.0 wt%.

As in any embodiment above, the polishing composition comprises an inorganic base which is an alkali metal hydroxide.

As in any embodiment above, the polishing composition wherein the alkali metal hydroxide is potassium hydroxide.

As in any embodiment above, the polishing composition comprises a base compound present at a concentration of from about 0.1 wt% to about 1 wt%.

As in any embodiment above, the polishing composition comprises a silicon oxide removal rate controller selected from the group consisting of N-cyclohexyl-3-aminopropanesulfonic acid (CAPS), 4-(cyclohexylamino)butane-1-sulfonic acid (CABS), 3-(cyclohexylamino)-2-hydroxy-1-propanesulfonic acid (CAPSO), N-cyclohexyl-2-aminoethanesulfonic acid (CHES), and a combination thereof.

As in any embodiment above, the polishing composition comprises a silicon oxide removal rate controller which has a pKa of from about 9.5 to about 11 (preferably from about 9.5 to about 10.8 and more preferably from about 9.5 to about 10.5) at 25°C.

As in any embodiment above, the polishing composition comprises a silicon oxide removal rate controller which is N-cyclohexyl-3-aminopropanesulfonic acid (CAPS).

As in any embodiment above, the polishing composition comprises a silicon oxide removal rate controller present at a concentration of from about 0.01 wt% to about 0.5 wt%.

As in any embodiment above, the polishing composition comprises a silicon oxide removal rate controller present at a concentration of from about 0.3 wt% to about 3.0 wt%.

As in any embodiment above, the polishing composition further comprises benzotriazole.

As in any embodiment above, the polishing composition further comprises benzotriazole which is present at a concentration of from about 0.01 wt% to about 0.15 wt%

As in any embodiment above, the polishing composition comprises an abrasive present at a concentration of

from about 0.1 wt% to about 2.5 wt%.

As in any embodiment above, the polishing composition further comprises an acid selected from the group consisting of citric acid, nitric acid, phosphoric acid, maleic acid, tartaric acid, 1-hydroxyethylidene-1,1-diphosphonic acid (HEDP), glycolic acid, lactic acid, malic acid, hydroxybutyric acid, and a combination thereof.

As in any embodiment above, a polishing composition wherein the acid is citric acid

As in any embodiment above, the polishing composition further comprises an acid present at a concentration of from about 0.01 wt% to about 1.0 wt%.

As in any embodiment above, the polishing composition wherein the pH ranges from about 9.5 to about 11 (preferably from about 9.5 to about 10.8).

As in any embodiment above, the polishing composition wherein the pH ranges from about 9.5 to about 10.6.

Further, as described herein, in some embodiments is a polishing composition comprising an abrasive, a base compound, a silicon oxide removal rate controller, and an oxidizer, wherein:

the abrasive is a silica abrasive with a primary particle size ranging from about 60 nm to about 70 nm, a secondary particle size ranging from about 110 nm to about 130 nm, its surface is unmodified, and it is present in a concentration of from about 0.1 wt% to about 2.5 wt%;

the base compound is potassium hydroxide and is present at a concentration of about 0.2 wt%. to about 0.5 wt%;

the silicon oxide removal rate controller is selected from the group consisting of N-cyclohexyl-3-aminopropanesulfonic acid (CAPS), 4-(cyclohexylamino)butane-1-sulfonic acid (CABS), 3-(cyclohexylamino)-2-hydroxy-1-propanesulfonic acid (CAPSO), and N-cyclohexyl-2-aminoethanesulfonic acid (CHES), and is present at a concentration of from about 0.8 wt% to about 1.2 wt%; and

the oxidizer is hydrogen peroxide and is present at a concentration of from about 0.8 wt% to about 1.2 wt%,

wherein the pH of the polishing composition is from about 9.5 to about 10.5.

As in any embodiment above, the polishing composition further comprises benzotriazole in a concentration of from about 0.05 wt% to about 0.15 wt%.

As in any embodiment above, the polishing composition further comprises citric acid in a concentration of from about 0.05 wt% to about 0.15 wt%.

As in any embodiment above, the polishing composition further has a silicon oxide removal rate (e.g., TEOS removal rate) of at least about 100 Å/min.

As in any embodiment above, the polishing composition further has a tantalum removal rate of at least about 120 Å/min.

As in any embodiment above, the polishing composition further has a copper removal rate of at least about 100 Å/min.

As in any embodiment above, the polishing object comprises one or more selected from the group consisting of silicon oxide, tantalum, and copper.

C. Methods of Using the Polishing Compositions

The polishing compositions described herein are useful for polishing any suitable substrate. In an embodiment, the substrate to be polished can be any suitable substrate, which comprises at least one layer of TEOS, Ta and/or Cu. Suitable substrates which comprise at least one layer of TEOS include, but are not limited to, semiconductors, flat panel displays, integrated circuits, (micro)electronic devices, high density interconnects, and memory cells.

As another example, the polishing composition can be used to polish a substrate, which comprises at least one layer of tantalum (Ta). Suitable substrates include, but are not limited to, capacitors, semiconductors, high-temperature devices, surface acoustic wave (SAW) filters, cell phones, batteries, and microelectronic devices.

As another example, the polishing composition can be used to polish a substrate comprising a silicon oxide layer. In another embodiment, the polishing composition can be used to polish a substrate comprising a copper (Cu) layer. Suitable substrates include, but are not limited to, flat panel displays, integrated circuits, semiconductors, high electrical and/or thermal conductivity materials, microelectromechanical systems (MEMS).

The substrate can further comprise at least one other layer, e.g., an insulating layer. The insulating layer can be a metal oxide, porous metal oxide, glass, organic polymer, fluorinated organic polymer, or any other suitable high- or low-K insulating layer. The insulating layer can comprise, consist essentially of, or consist of silicon oxide, SiN, or combinations thereof. The silicon oxide layer can comprise, consist essentially of, or consist of any suitable silicon oxide, many of which

are known in the art. For example, the silicon oxide layer can comprise TEOS, high density plasma (HDP) oxide, borophosphosilicate glass (BPSG), high aspect ratio process (HARP) oxide, spin-on dielectric (SOD) oxide, chemical vapor deposition (CVD) oxide, plasma-enhanced tetraethyl orthosilicate (PETEOS), thermal oxide, or undoped silicate glass.

In a specific embodiment, the silicon oxide layer is TEOS. In some embodiments, such silicon oxide layer corresponds to the TEOS layer described above. The substrate can further comprise a metal layer. In a specific embodiment, the metal layer is tantalum (Ta). In another specific embodiment, the metal layer is copper (Cu). In some embodiments, the substrate can have more than one metal layer.

The subject matter disclosed herein also comprises a method for polishing a substrate with the polishing compositions described herein. The method of polishing a substrate comprises: (a) providing a substrate, (b) providing a polishing composition described herein, (c) applying the polishing composition to at least a portion of the substrate, and (d) abrading at least a portion of the substrate with the polishing composition to polish the substrate.

As in any embodiment above, the polishing object comprises one or more selected from the group consisting of silicon oxide, tantalum, and copper.

For the polishing compositions disclosed herein, the polishing compositions have a silicon oxide removal rate (e.g., TEOS removal rate) of at least ≥ about 60 Å/min; at least ≥ about 70 Å/min; at least ≥ about 74 Å/min; at least ≥ about 80 Å/min; at least ≥ about 85 Å/min; at least ≥ about 90 Å/min; at least ≥ about 95 Å/min; at least ≥ about 100 Å/min; at least ≥ about 105 Å/min; at least ≥ about 110, or at least ≥ about 115 Å/min. In some embodiments, the silicon oxide removal rate (e.g., TEOS removal rate) is in a range of from about 60 Å/min to about 150 Å/min; from about 70 Å/min to about 125 Å/min; from about 79 Å/min to about 120 Å/min; from about 98 Å/min to about 118 Å/min; from about 98 Å/min to about 111 Å/min; or from about 100 Å/min to about 111 Å/min. In some embodiments, the silicon oxide removal rate (e.g., TEOS removal rate) is in a range of from about 95 Å/min to about 130 Å/min; from about 95 Å/min to about 120 Å/min; from about 100 Å/min to about 125 Å/min; from about 105 Å/min to about 120 Å/min; from about 105 Å/min to about 115 Å/min; or from about 110 Å/min to about 115 Å/min.

For the polishing compositions disclosed herein, the polishing compositions have a Ta removal rate of at least ≥ about 75 Å/min; at least ≥ about 85 Å/min; at least ≥ about 95 Å/min; at least ≥ about 105 Å/min; at least ≥ about 110 Å/min; at least ≥ about 115 Å/min; at least ≥ about 120 Å/min; at least ≥ about 125 Å/min; at least ≥ about 130 Å/min; at least ≥ about 135 Å/min; at least ≥ about 140; or at least ≥ about 145 Å/min Å/min. In some embodiments, the Ta removal rate is in a range of from about 75 Å/min to about 200 Å/min; from about 75 Å/min to about 175 Å/min; from about 100 Å/min to about 160 Å/min; from about 115 Å/min to about 160 Å/min; from about 125 Å/min to about 155 Å/min; from about 130 Å/min to about 155 Å/min; from about 135 Å/min to about 155 Å/min; or from about 140 Å/min to about 150 Å/min. In some embodiments, the Ta removal rate is in a range of from about 100 Å/min to about 145 Å/min; from about 105 Å/min to about 135 Å/min; from about 115 Å/min to about 130 Å/min; from about 120 Å/min to about 130 Å/min; or from about 125 Å/min to about 130 Å/min.

For the polishing compositions disclosed herein, the polishing compositions have a Cu removal rate of at least ≥ about 40 Å/min; at least ≥ about 50 Å/min; at least ≥ about 60 Å/min; at least ≥ about 70 Å/min; at least ≥ about 80 Å/min; at least ≥ about 90 Å/min; at least ≥ about 100 Å/min; at least ≥ about 135 Å/min; at least ≥ about 110 Å/min; or at least ≥ about 115 Å/min. In some embodiments, the Cu removal rate is in a range of from about 50 Å/min to about 150 Å/min; from about 70 Å/min to about 141 Å/min; from about 80 Å/min to about 141 Å/min; from about 90 Å/min to about 133 Å/min; from about 100 Å/min to about 130 Å/min; 110 Å/min to about 130 Å/min; or from about 115 Å/min to about 130 Å/min.

According to some embodiments, the polishing compositions preferably have a small difference between the silicon oxide removal rate (e.g., TEOS removal rate) and the Ta removal rate and/or Cu removal rate. For example, the difference between the silicon oxide removal rate (e.g., TEOS removal rate) and the Ta removal rate and/or Cu removal rate is 50 Å/min or less, 40 Å/min or less, 30 Å/min or less, or 20 Å/min or less.

Accordingly, as described herein, in some embodiments are methods of using the polishing compositions, where the methods comprise the steps of: a) providing the polishing composition described herein; b) providing a substrate, wherein the substrate comprises a silicon oxide-containing layer (e.g., TEOS-containing layer); and c) polishing the substrate with the polishing composition to provide a polished substrate.

As in any embodiment above, a method wherein the substrate further comprises a tantalum-containing layer and/or a copper-containing layer.

As in any embodiment above, a method wherein the polishing object comprises one or more selected from the group consisting of silicon oxide, tantalum, and copper.

As in any embodiment above, a method wherein the method has a silicon oxide removal rate (e.g., TEOS removal rate) of at least about 100 Å/min.

As in any embodiment above, a method wherein the method has a tantalum removal rate of at least about 120 Å/min.

As in any embodiment above, a method wherein the method has a copper removal rate of at least about 100 Å/min.

As in any embodiment above, a method wherein the substrate is a semiconductor.

[Examples]

D. Examples

The present invention will be described in more detail with the following Examples and Comparative Examples. The following preparations and examples are given to enable those skilled in the art to more clearly understand and to practice the present invention. They should not be considered as limiting the scope of the invention, but merely as being illustrative and representative. Unless otherwise specified, "%" and "parts" mean "% by mass" and "parts by mass", respectively. In the following Examples, the operations were carried out under the conditions of room temperature (20°C or more and 25°C or less)/relative humidity of 30% RH or more and 50% RH or less, unless otherwise specified.
In one aspect, disclosed are methods of making the polishing compositions. In another aspect are disclosed methods of using the polishing compositions to polish materials.

Example 1

The following Slurries 1-25 were prepared as polishing compositions. Then, the prepared Slurries 1-25 were used to polish the polishing objects under the following polishing conditions, and the removal rates were evaluated. In addition, MPS Gap was evaluated for the stability of Slurries 1-25 by the following method.

Formulation Examples

Tables 3-5 show the composition of each slurry. An abrasive, a base compound, a silicon oxide removal rate controller, an oxidizer, an acid, and benzotriazole were added to pure water as a dispersion medium at room temperature (25°C) and mixed with stirring at room temperature (25°C) for 30 minutes to prepare each slurry. Pure water was added in such an amount that the total amount of the slurry was 100% by mass. Table 1 and Table 2 show the abrasive and the silicon oxide removal rate controller (denoted as "TEOS RR agent" in Tables 3-5) in detail, respectively.

<Removal Rate Evaluation>

«Polishing Conditions»

- Materials and tools used:
- Polishing conditions
- Instrumentation: 300 mm Polisher Reflexion LK
- Plate rotation speed: 73 rpm
- Head rotation speed: 6
- Flow rate: 200 mL/min
- Down force: 1 psi
- Polishing time: 60 sec
- Pad: Fujibo H800
- Pad conditioner: 30 Nylon brush
- Dilution factor: 1x
- 1.0% $H_2O_2$

Polishing recipe:

- Down force: 1.0 psi,
- rotation: 73/67 rpm,
- slurry flow rate: 200 mL/min,
- Polishing time: 60 sec

«Polishing Object»

Three wafer types: PE-10kA-TEOS on Si substrate; 4kA-Ta on 3kA thermal oxide Si substrate; and 10kA-EP-Cu on Si substrate.

Since TEOS was used as a silicon oxide film in the present example, the silicon oxide film is hereinafter referred to as "TEOS".

Conditions for etch rate:

- 25°C for 3 min
- wafer coupon size: 1.5 in × 1.5 in

<Stability Evaluation>

<<Measurement of MPS Gap>>

Stability testing (MPS Gap after three days) evaluated changes in the mean particle size (MPS) of the abrasives using a Malvern Panalytical ZetaSizer Nano light scattering system). Specifically, the MPS Gap was determined by calculating the difference ($MPS^2$ - $MPS^1$ (unit: nm)) between the mean particle size $MPS^1$ immediately after preparation of the composition and the mean particle size $MPS^2$ after storage at 55°C for three days.

Example 2

The above-mentioned polishing objects were polished using Slurries 1-25 prepared above under the above-mentioned polishing conditions.

Evaluation of various Polishing Compositions

For this study several abrasives (numbered as Type 1-5) were investigated where the abrasives differ in properties such as primary particle size, secondary particle size, silanol (SiOH) density, and zeta potential. The results are summarized in Table 1 below.

[Table 1]

Table 1: Abrasive Information

| Type | surface modification | primary particle size [nm] (1) | secondary particle size [nm] (1) | (2)/(1) ratio | D90 [nm] | D50 [nm] | D10 [nm] | D90/ D50 | D90/ D10 | True specific gravity [g/cc] | Silanol group density [$1/nm^2$] | Method of production | Zeta potential (mV; at composition use) | Aspect ratio |
|---|---|---|---|---|---|---|---|---|---|---|---|---|---|---|
| 1 | sulfonic | 30 | 70 | 2.3 | 81 | 70 | 58 | 1.2 | 1.4 | 1.12 | 6.2 | sol gel | -38 | 1.2 |
| 2 | none | 30 | 70 | 2.3 | 81 | 70 | 58 | 1.2 | 1.4 | 1.12 | 6.2 | sol gel | -38 | 1.2 |
| 3 | sulfonic | 12 | 30 | 2.5 | 42 | 30 | 21 | 1.4 | 2.0 | 1.12 | 6.2 | sol gel | -41 | 1.3 |
| 4 | none | 36 | 58 | 1.6 | 101 | 58 | 34 | 1.7 | 3.0 | 1.12 | 5.8 | sol gel | -38 | 1.4 |
| 5 | none | 65 | 121 | 1.9 | 211 | 121 | 74 | 1.7 | 2.9 | 1.12 | 5.9 | sol gel | -39 | 1.6 |

In addition, a series of various silicon oxide removal rate controllers were examined as well. The silicon oxide removal rate controllers numbered as Type 4-10 are zwitterions, whereas the silicon oxide removal rate controllers numbered as Type 1-3 are bicarbonates, nitrates and sulfates, respectively. Table 2 shows all of the silicon oxide removal rate controllers used.

[Table 2]

Table 2. Silicon oxide removal rate controller Information

| Type | Chemical | pKa (25°C) | pKa (40°C) |
|---|---|---|---|
| **1** | Potassium bicarbonate | **10.3** | |
| **2** | Potassium nitrate | | |
| **3** | Ammonium sulfate | | |
| **4** | CAPS | **10.4** | 10.8 |
| **5** | CABS | **10.7** | 10.9 |
| **6** | CAPSO | **9.6** | 9.4 |
| **7** | CHES | **9.5** | 9.4 |
| **8** | TAPS | **8.4** | 7.1 |
| **9** | POPSO | **7.8** | 7.6 |
| **10** | HEPES | **7.5** | 7.3 |

CAPS: N-cyclohexyl-3-aminopropanesulfonic acid
CABS: 4-(cyclohexylamino)butane-1 -sulfonic acid
CAPSO: 3-(cyclohexylamino)-2-hydroxy-1-propanesulfonic acid
CHES: N-cyclohexyl-2-aminoethanesulfonic acid
TAPS: N-[tris(hydroxymethyl)methyl]-3-aminopropanesulfonic acid
POPSO: Piperazine-1,4-bis(2-hydroxypropanesulfonic acid)
HEPES: 2-[4-(2-hydroxyethyl)-1-piperazinyl]ethanesulfonic acid

As illustrated in Table 3, Slurries 5 and 16-19 were screened for their various abrasive types. The slurry stability, TEOS, Ta, and Cu removal rates (RR) were evaluated. The slurries (polishing compositions) of the aspect with high stability were desirable. The data in Table 3 shows that Slurries 5 and 16-19 had high stability. Generally, slurries with high RR for TEOS and/or Ta and/or Cu were also desirable. The data in Table 3 shows that Slurry-5 and Slurry-19 gave higher TEOS RR, higher Ta RR, and higher Cu RR compared to the other slurries (i.e., Slurry-16, Slurry-17, and Slurry-18). In particular, Slurry-5, which comprises Abrasive Type 5, produced the highest TEOS RR. These results demonstrate that abrasives which are not surface-modified with a low silanol (SiOH) density and a high aspect ratio can provide slurries that exhibit high TEOS RRs.

[Table 3]

**Table 3. Effects of Abrasive Type**

| Slurry | Abrasive | | Base | Acid | | Corrosion inhibitor | | TEOS RR controller | | $H_2O_2$ | PH | Removal Rate [Å/min] | | | Stability |
|---|---|---|---|---|---|---|---|---|---|---|---|---|---|---|---|
| | Type | wt% | | Type | wt% | Type | wt% | Type | wt% | wt% | | TEOS | Ta | Cu | MPS Gap after three days |
| 16 | 1 | 2 | KOH | Citric Acid | 0.1 | BTA | 0.1 | 4 | 0.2 | 1 | 10 | 93 | 122 | 89 | 4 |
| 17 | 2 | 2 | KOH | Citric Acid | 0.1 | BTA | 0.1 | 4 | 0.2 | 1 | 10 | 91 | 121 | 90 | 4 |
| 18 | 3 | 2 | KOH | Citric Acid | 0.1 | BTA | 0.1 | 4 | 0.2 | 1 | 10 | 67 | 76 | 66 | 3 |
| 19 | 4 | 2 | KOH | Citric Acid | 0.1 | BTA | 0.1 | 4 | 0.2 | 1 | 10 | 102 | 128 | 104 | 6 |
| 5 | 5 | 2 | KOH | Citric Acid | 0.1 | BTA | 0.1 | 4 | 0.2 | 1 | 10 | 111 | 127 | 113 | 6 |

Next, Slurries 5 and 21-25 were screened for screened for their various acid components. As can be seen in the table below slurries with acids such as citric acid (Slurry-5), nitric acid (Slurry-21), phosphoric acid (Slurry-22), maleic acid (Slurry-23), tartaric acid (Slurry-24) and 1-hydroxyethylidene-1,1-diphosphonic acid (HEDP; Slurry-25) were screened for their TEOS, Ta, and/or Cu RR, and stability. The data in Table 4 shows that Slurries 5 and 21-25 had high stability. The data in Table 4 also shows that Slurries 5, 22, and 24 all provided high removal rates for TEOS, Ta, and Cu. However, Slurry-5, which comprises citric acid, exhibited the best stability.

[Table 4]

**Table 4. Effects of Acid Type**

| Slurry | Abrasive | | Base | Acid | | Corrosion inhibitor | | TEOS RR controller | | $H_2O_2$ | PH | Removal Rate [Å/min] | | | Stability |
|---|---|---|---|---|---|---|---|---|---|---|---|---|---|---|---|
| | Type | wt% | | Type | wt% | Type | wt% | Type | wt% | wt% | | TEOS | Ta | Cu | MPS Gap after three days |
| 5 | 5 | 2 | KOH | Citric Acid | 0.1 | BTA | 0.1 | 4 | 0.2 | 1 | 10 | 111 | 127 | 113 | 4 |
| 21 | 5 | 2 | KOH | Nitric Acid | 0.1 | BTA | 0.1 | 4 | 0.2 | 1 | 10 | 107 | 126 | 128 | 3 |
| 22 | 5 | 2 | KOH | Phosphoric Acid | 0.1 | BTA | 0.1 | 4 | 0.2 | 1 | 10 | 109 | 126 | 131 | 2 |
| 23 | 5 | 2 | KOH | Maleic Acid | 0.1 | BTA | 0.1 | 4 | 0.2 | 1 | 10 | 107 | 123 | 133 | 3 |
| 24 | 5 | 2 | KOH | Tartaric Acid | 0.1 | BTA | 0.1 | 4 | 0.2 | 1 | 10 | 113 | 125 | 130 | 3 |
| 25 | 5 | 2 | KOH | HEDP | 0.1 | BTA | 0.1 | 4 | 0.2 | 1 | 10 | 104 | 122 | 117 | 3 |

Next, several slurries were prepared to investigate the effects of the type of silicon oxide removal rate controller that is present in the polishing composition on its TEOS, Ta, and Cu RR. As is illustrated in Table 5 below, slurries (such as Slurries 5-11 and 13-15) with zwitterions having a pKa of 7-11 as silicon oxide removal rate controllers were able to provide high stability and high TEOS. As is illustrated in Table 5 below, slurries (such as Slurry-5, Slurry-6, Slurry-7 and Slurry-8) with zwitterions having a pKa of at least 9.4 as silicon oxide removal rate controllers (such as silicon oxide removal rate controllers 4, 5, 6, and 7) were able to provide high stability and high TEOS, Ta and Cu RRs. By contrast, slurries (such as Slurry-9, Slurry-10 and Slurry-11) with zwitterions having a pKa of less than 9.4 as silicon oxide removal rate controllers (such as 8, 9 and 10) provided significantly lower TEOS removal rates. In addition, although Slurry-2, Slurry-3, and Slurry-4, which have silicon oxide removal rate controllers that are not zwitterions exhibit good removal rates for TEOS, Ta, and Cu, they are significantly less stable compared to the other slurries in Table 5.

[Table 5]

**Table 5. Effect of different silicon oxide removal rate controllers**

| Slurry | Abrasive | | Base | Acid | | Corrosion inhibitor | | TEOS RR controller | | $H_2O_2$ | PH | Removal Rate [Å/min] | | | Stability |
|---|---|---|---|---|---|---|---|---|---|---|---|---|---|---|---|
| | Type | wt% | | Type | wt% | Type | wt% | Type | wt% | wt% | | TEOS | Ta | Cu | Mean Particle Size (MPS) Gap after three days [nm] |
| 1 | 5 | 2 | KOH | Citric Acid | 0.1 | BTA | 0.1 | n/a | n/a | 1 | 9.6 | **67** | **137** | **112** | 2 |
| 2 | 5 | 2 | KOH | Citric Acid | 0.1 | BTA | 0.1 | 1 | 0.2 | 1 | 10 | 117 | 150 | 128 | 30 |
| 3 | 5 | 2 | KOH | Citric Acid | 0.1 | BTA | 0.1 | 2 | 0.2 | 1 | 10 | 118 | 144 | 133 | 33 |
| 4 | 5 | 2 | KOH | Citric Acid | 0.1 | BTA | 0.1 | 3 | 0.2 | 1 | 10 | 115 | 126 | 141 | 35 |
| 5 | 5 | 2 | KOH | Citric Acid | 0.1 | BTA | 0.1 | 4 | 0.2 | 1 | 10 | **111** | 127 | 113 | 4 |
| 6 | 5 | 2 | KOH | Citric Acid | 0.1 | BTA | 0.1 | 5 | 0.2 | 1 | 10 | **110** | 128 | 117 | 3 |
| 7 | 5 | 2 | KOH | Citric Acid | 0.1 | BTA | 0.1 | 6 | 0.2 | 1 | 10 | **100** | 125 | 118 | 4 |
| 8 | 5 | 2 | KOH | Citric Acid | 0.1 | BTA | 0.1 | **7** | 0.2 | 1 | 10 | **98** | 126 | 119 | 4 |
| 9 | 5 | 2 | KOH | Citric Acid | 0.1 | BTA | 0.1 | **8** | 0.2 | 1 | 10 | **74** | 138 | 117 | 4 |
| 10 | 5 | 2 | KOH | Citric Acid | 0.1 | BTA | 0.1 | **9** | 0.2 | 1 | 10 | **79** | 135 | 118 | 5 |
| 11 | 5 | 2 | KOH | Citric Acid | 0.1 | BTA | 0.1 | **10** | 0.2 | 1 | 10 | **73** | 141 | 121 | 3 |
| 12 | 5 | 2 | KOH | Citric Acid | 0.1 | BTA | 0.1 | **1** | 0.05 | 1 | 10 | 98 | 142 | 121 | 17 |
| 13 | 5 | 2 | KOH | Citric Acid | 0.1 | BTA | 0.1 | **4** | 0.05 | 1 | 10 | 99 | 132 | 112 | 3 |
| 14 | 5 | 2 | KOH | Citric Acid | 0.1 | BTA | 0.1 | **4** | 0.03 | 1 | 10 | 98 | 133 | 113 | 3 |
| 15 | 5 | 2 | KOH | Citric Acid | 0.1 | BTA | 0.1 | **4** | 0.01 | 1 | 10 | 86 | 135 | 105 | 3 |

Lastly, Table 5 shows that varying the amount of silicon oxide removal rate controller modulates that TEOS RR. Specifically, Slurry-5, Slurry-13, Slurry-14, and Slurry-15 were prepared with amounts of the silicon oxide removal rate controller ranging from 0.01 wt% to 0.2 wt%. A general increase in TEOS RR can be observed as the amount of silicon oxide removal rate controller in the slurry increases.

It will be apparent to those skilled in the art that various modifications and variations can be made in the present invention without departing from the scope of the invention. Other aspects of the invention will be apparent to those skilled in the art from consideration of the specification and practice of the invention disclosed herein. It is intended that the specification and examples be considered as exemplary only, with a true scope of the invention being indicated by the following claims.

This application is based on the foreign language specification submitted as attachment to the application of U.S. Provisional Application No. 63/537,636, filed on Sep. 11, 2023, the disclosure of which is incorporated herein by reference in its entirety.

## Claims

**1.** A polishing composition comprising an abrasive, a base compound, a silicon oxide removal rate controller, and an oxidizer, wherein

the abrasive is a silica abrasive with a primary particle size ranging from about 30 nm to about 70 nm and a secondary particle size ranging from about 50 nm to about 130 nm;
the base compound is an inorganic base;
the silicon oxide removal rate controller is a zwitterion; and
the oxidizer is a peroxide.

**2.** The polishing composition of claim 1, wherein the silicon oxide removal rate controller has a pKa ranging from about 7 to about 11 at 25°C.

**3.** The polishing composition of claim 1 or claim 2, wherein the abrasive is not surface-modified.

**4.** The polishing composition of claim 1 or claim 2, wherein the abrasive has a ratio of secondary particle size to primary particle size ranging from about 1.5 to about 2.0.

**5.** The polishing composition of claim 1 or claim 2, wherein the inorganic base is an alkali metal hydroxide.

**6.** The polishing composition of claim 1 or claim 2, wherein the silicon oxide removal rate controller is selected from the group consisting of N-cyclohexyl-3-aminopropanesulfonic acid (CAPS), 4-(cyclohexylamino)butane-1-sulfonic acid (CABS), 3-(cyclohexylamino)-2-hydroxy-1-propanesulfonic acid (CAPSO), N-cyclohexyl-2-aminoethanesulfonic acid (CHES), and a combination thereof.

**7.** The polishing composition of claim 1 or claim 2, wherein the silicon oxide removal rate enhancer has a pKa of from about 9.5 to about 11 at 25 ºC.

**8.** The polishing composition of claim 1 or claim 2, wherein the silicon oxide removal rate controller is N-cyclohexyl-3-aminopropanesulfonic acid (CAPS).

**9.** The polishing composition of claim 1 or claim 2, wherein the silicon oxide removal rate controller is present at a concentration of from about 0.05 wt% to about 0.2 wt%.

**10.** The polishing composition of claim 1 or claim 2, wherein the pH ranges from about 9.5 to about 10.6.

**11.** A polishing composition comprising an abrasive, a base compound, a silicon oxide removal rate controller, and an oxidizer, wherein

the abrasive is a silica abrasive with a primary particle size ranging from about 60 nm to about 70 nm, a secondary particle size ranging from about 110 nm to about 130 nm, its surface is unmodified, and it is present in a concentration of from about 0.1 wt% to about 2.5 wt%;
the base compound is potassium hydroxide and is present at a concentration of from about 0.2 wt% to about 0.5

wt%;
the silicon oxide removal rate controller is selected from the group consisting of N-cyclohexyl-3-aminopropanesulfonic acid (CAPS), 4-(cyclohexylamino)butane-1-sulfonic acid (CABS), 3-(cyclohexylamino)-2-hydroxy-1-propanesulfonic acid (CAPSO), and N-cyclohexyl-2-aminoethanesulfonic acid (CHES), and is present at a concentration of from about 0.8 wt% to about 1.2 wt%; and
the oxidizer is hydrogen peroxide and is present at a concentration of from about 0.8 %wt to about 1.2 %wt,
wherein the pH of the polishing composition is from about 9.5 to about 10.5.

**12.** The polishing composition of claim 1 or claim 2, wherein t the polishing object comprises one or more selected from the group consisting of silicon oxide, tantalum, and copper.

**13.** A method for polishing a substrate, the method comprising the steps of:

(a) providing a polishing composition of claim 1 or claim 2;
(b) providing a substrate, wherein the substrate comprises a silicon oxide-containing layer; and
(c) polishing the substrate with the polishing composition to provide a polished substrate.

**14.** The method of claim 16, wherein the substrate further comprises a tantalum-containing layer and/or a copper-containing layer.

**15.** The method of claim 16, wherein the substrate is a semiconductor.

Europäisches Patentamt
European Patent Office
Office européen des brevets

# EUROPEAN SEARCH REPORT

Application Number
EP 24 19 8184

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 8 262 435 B2 (KUNITANI EIICHIROU [JP]; BABA ATSUSHI [JP] ET AL.) 11 September 2012 (2012-09-11) * column 12, line 66 - column 13, line 8; claims 1-7; examples 2, 3, 4; table 1 * * column 13, line 19 - column 14, line 32 * | 1-5,7,9, 10,12-15 | INV. C09G1/02 C09K3/14 H01L21/3105 H01L21/321 |
| X | US 2010/164106 A1 (LEE TAE YOUNG [KR] ET AL) 1 July 2010 (2010-07-01) * paragraphs [0012] - [0021], [0026] - [0039]; claims 1-16; example 2; tables 1, 2 * | 1-5,7,9, 12-15 | |
| X,P | US 2023/295465 A1 (KIM HOOI-SUNG [US] ET AL) 21 September 2023 (2023-09-21) * Slurries 01 and 03 in table 1; paragraph [0084]; tables A, B * | 1,3-5,9, 10,12, 13,15 | |
| X | WO 2020/120520 A1 (BASF SE [DE]) 18 June 2020 (2020-06-18) | 1-5,7,9, 10,12-15 | TECHNICAL FIELDS SEARCHED (IPC) |
| Y | * page 11, lines 17-33; claims 1-15; examples 2, 4, 6 * * page 42, line 13 - page 46, line 8 * | 6,8,11 | C09G C09K H01L |
| Y | EP 2 662 427 A2 (AIR PROD & CHEM [US]) 13 November 2013 (2013-11-13) * paragraphs [0047] - [0051], [0064]; claims 1-7 * | 6,8,11 | |

The present search report has been drawn up for all claims

2

| Place of search | Date of completion of the search | Examiner |
|---|---|---|
| Munich | 15 January 2025 | Schmitt, Johannes |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO.

EP 24 19 8184

This annex lists the patent family members relating to the patent documents cited in the above-mentioned European search report. The members are as contained in the European Patent Office EDP file on
The European Patent Office is in no way liable for these particulars which are merely given for the purpose of information.

15-01-2025

| Patent document cited in search report | Publication date | Patent family member(s) | Publication date |
|---|---|---|---|
| US 8262435 B2 | 11-09-2012 | EP 2123726 A1 | 25-11-2009 |
| | | JP 5472585 B2 | 16-04-2014 |
| | | JP 2010004023 A | 07-01-2010 |
| | | US 2009291620 A1 | 26-11-2009 |
| US 2010164106 A1 | 01-07-2010 | CN 101768412 A | 07-07-2010 |
| | | US 2010164106 A1 | 01-07-2010 |
| US 2023295465 A1 | 21-09-2023 | NONE | |
| WO 2020120520 A1 | 18-06-2020 | CN 113195656 A | 30-07-2021 |
| | | EP 3894494 A1 | 20-10-2021 |
| | | IL 283783 A | 29-07-2021 |
| | | JP 2022512426 A | 03-02-2022 |
| | | KR 20210102931 A | 20-08-2021 |
| | | TW 202024291 A | 01-07-2020 |
| | | US 2022064485 A1 | 03-03-2022 |
| | | US 2024002698 A1 | 04-01-2024 |
| | | WO 2020120520 A1 | 18-06-2020 |
| EP 2662427 A2 | 13-11-2013 | CN 103387796 A | 13-11-2013 |
| | | EP 2662427 A2 | 13-11-2013 |
| | | EP 3333232 A2 | 13-06-2018 |
| | | KR 20130126536 A | 20-11-2013 |
| | | TW 201345988 A | 16-11-2013 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 63537636

### Non-patent literature cited in the description


- **G. W. SEARS**. Determination of Specific Surface Area of Colloidal Silica by Titration with Sodium Hydroxide. *Analytical Chemistry*, 1956, vol. 28 (12), 1982-1983
- Sulfonic acid-functionalized silica through quantitative oxidation of thiol groups. *Chem. Commun.*, 2003, vol. 2, 246-247
- Novel Silane Coupling Agents Containing a Photolabile 2-Nitrobenzyl Ester for Introduction of a Carboxy Group on the Surface of Silica Gel. *Chemistry Letters*, 2000, vol. 29 (3), 228-229